# EUROPEAN PATENT APPLICATION

(11) **EP 4 397 718 A1**
(43) Date of publication of application: **10.07.2024**
(21) Application number: 22864613.9
(22) Date of filing: 31.08.2022
(51) Int. Cl.: C08L 83/04, C08J 3/20, C08J 5/00, C08K 3/00, H01L 23/29, H01L 23/31

(54) **GRANULAR CURABLE SILICONE COMPOSITION, CURED PRODUCT OF SAME, AND METHOD FOR PRODUCING SAME**

(30) Priority: 31.08.2021 JP 2021140799
(71) Applicant: Dow Toray Co., Ltd., Tokyo 140-8617 (JP)
(72) Inventor: YAMAZAKI Ryosuke, Ichihara-shi Chiba 299-0108 (JP); MATSUSHIMA Hidenori, Ichihara-shi Chiba 299-0108 (JP); OZAKI Koichi, Ichihara-shi Chiba 299-0108 (JP); IMAIZUMI Toru, Ichihara-shi Chiba 299-0108 (JP)
(74) Representative: Murgitroyd & Company
(86) International application number: PCT/JP2022/032737
(87) International publication number: WO 2023/033031

(57) **Abstract**

[Problem]

To provide: a curable silicone composition that can contain a large amount of a functional inorganic filler, provides a cured product with excellent hot-melt, gap-filling, and homogeneity properties characterized by high fluidity at high temperatures, is suitable for transfer molding and other molding or sealing processes, generates little dust, and has excellent handling workability; a manufacturing method with excellent production efficiency and homogeneity; and the like.

[Solution]

A granular curable silicone composition containing (A) an organopolysiloxane resin containing at least 20 mol% or more T units, (B) a curing agent, and (C) a functional inorganic filler, wherein the amount of component (C) is 400 to 3000 parts by mass relative to 100 parts by mass of component (A) and component (B), the composition is a solid at 25°C and has a melt viscosity of 200 Pa·s or less as measured by a flow tester at 180°C, and the average particle size thereof is in the range of 0.1 to 10.0 mm; and an application thereof.

## Description

### TECHNICAL FIELD

The present invention relates to a granular curable silicone composition that has hot-melt properties and high fluidity at high temperatures, and provides a cured product with excellent gap-filling properties and homogeneity. The present invention further relates to a cured product containing the granular curable silicone composition, a method for molding the cured product, and applications such as semiconductor devices and the like provided with the cured product. Note that in the present invention, the property of being solid at 25°C but showing viscosity at 180°C is referred to as a "hot-melt property".

### BACKGROUND ART

Curable silicone compositions are utilized in a wide range of industrial fields because they are cured to form cured products having excellent heat resistance, cold resistance, electrical insulation, weather resistance, water repellency, and transparency. In general, the cured product of such a curable silicone composition is also suitable as a sealing agent for optical materials and semiconductor devices because discoloration is less likely to occur as compared with other organic materials and there is less deterioration of physical properties. In contrast, in recent years, hot-melt curable silicone compositions have been widely used as sealing agents for optical materials and semiconductor devices.

In Patent Documents 1 and 2, the present applicant has proposed hot-melt granular curable silicone compositions for molding, which mainly contain a resinous silicone and can be used for the aforementioned applications. However, the granular compositions presented in these inventions are fine-grained, with a particle size of 100 µm or less, and no granular compositions that have been compositionally homogenized in advance by melt kneading or the like are disclosed. Therefore, it has proven to be difficult to handle because of the risk of dust generation when used in granular form. Furthermore, the granular silicone composition is not a compositionally homogeneous and homogenized granular composition in a form in which components are mixed by a mechanical force, and thus is difficult to use in a molding process such as compression molding or press molding, which do not involve material movement and do not apply shear pressure. Therefore, transfer molding is recommended in the documents.

On the other hand, Patent Document 3 discloses a powder hot-melt composition using a resin-linear siloxane block copolymer and proposes particles having an average particle size not exceeding 500 µm, flakes uniformly mixed using a twin-screw extruder using a toluene solvent or other solvent, and the like. However, although the same document indicates that a reinforcing filler may be included at a ratio of 0.1% to approximately 95%, the composition has a high melt viscosity, particularly at 180°C. Moreover, when filled with a large amount of a functional inorganic filler, the composition does not melt even when exposed to high temperatures and thus is not particularly suitable for a transfer molding process. In other words, Patent Document 3 does not disclose a hot-melt composition and a granular product thereof containing a functional inorganic filler with a melt viscosity of 200 Pa·s or less at 180°C and more than 400 parts by mass per 100 parts by mass of the total amount of a silicone component and curing agent.

Furthermore, these documents do not specifically disclose a granular curable silicone composition with a relatively large average particle size that contains a relatively large amount of an inorganic filler, has favorable hot-melt properties, and is homogenized through a heating and melting step.

### RELATED ART DOCUMENTS

### Patent Documents

Patent Document 1: WO 2018/030288
Patent Document 2: WO 2018/235491
Patent Document 3: Japanese PCT Application 2016-522978

### SUMMARY OF THE INVENTION

### PROBLEM TO BE SOLVED BY THE INVENTION

An object of the present invention is to provide: a curable silicone composition that can contain a large amount of a functional inorganic filler, provides a cured product with excellent hot-melt, gap-filling, and homogeneity properties characterized by high fluidity at high temperatures, is suitable for transfer molding, compression molding, press molding, and other molding or sealing processes, generates little dust, and has excellent handling workability; a manufacturing method with excellent production efficiency and homogeneity; and the like. Furthermore, the present invention provides: a cured product obtained by curing the curable silicone composition; a member for a semiconductor device including the cured product; a semiconductor device having the cured product; and a method for molding a cured product.

### MEANS FOR SOLVING THE PROBLEM

As a result of extensive studies, the present inventors discovered that the aforementioned problems can be solved by a granular curable silicone composition containing: (A) an organopolysiloxane resin containing at least 20 mol% or more of a siloxane unit as expressed by RSiO_{3/2} (where R represents a monovalent hydrocarbon group) with respect to all siloxane units; (B) a curing agent; and (C) a functional inorganic filler, wherein the amount of component (C) is 400 to 3000 parts by mass relative to a total of 100 parts by mass of component (A) and component (B), the composition is a solid at 25°C and has a melt viscosity of 200 Pa·s or less as measured by a flow tester at 180°C, and the average particle size thereof is in the range of 0.1 to 10.0 mm, thereby arriving at the present invention.

The granular curable silicone composition is compositionally homogenized by melt kneading in the temperature range of 50 to 150°C, and then is molded into a granular form. Furthermore, the granular molded product according to the present invention may be tablet molded as a pellet molded product or tablet molded product.

Furthermore, the aforementioned problems are solved by the aforementioned granular molded product or other cured product, use thereof as a member for a semiconductor device, and a method for molding the cured product.

### EFFECT OF THE INVENTION

The granular curable silicone composition of the present invention has hot-melt properties, and even though the composition contains a large amount of a functional inorganic filler, the composition has excellent melting and curing properties characterized by high fluidity at high temperatures. Moreover, the composition is granular with low dust generation, and thus has excellent handling workability and homogeneity of components. Therefore, a cured product thereof is characterized by the high hardness and low coefficient of linear expansion, and is particularly suitable for use as sealing, molding, and protective members for a semiconductor device. Furthermore, with the method for manufacturing a granular molded product according to the present invention, efficient production is possible using only a simple mixing process, and a method for molding a cured product using the granular molded product according to the present invention and the like can efficiently manufacture a member for a semiconductor device containing the cured product, a semiconductor device having the cured product, and the like.

### BRIEF DESCRIPTION OF THE DRAWINGS

FIG. 1 is a diagram of a granular curable silicone composition obtained by Manufacturing Example 1 (Comparative Example 1) before being melt kneaded and crushed by a heat press.
FIG. 2 is a diagram of a granular curable silicone composition obtained by Example 1 before being crushed by a heat press.

### DESCRIPTION OF THE PREFERRED EMBODIMENTS

### [Granular Form]

In addition to having hot-melt properties characterized by compositional features and specific melting properties, the curable silicone composition of the present invention is characterized by the granular form thereof. Herein, the term "granular" means that each component configuring the composition is at least substantially homogenized and in the form of granules having a certain average particle size, and may not solve the problem of the present invention in granular mixtures in which each component is simply mixed using a mechanical force, or in compositions that are not granulated for the purpose of compositional homogeneity. Herein, in the granular composition according to the present invention, "average particle size" shall mean the primary average particle size of granules containing the homogenized composition, unless otherwise defined.

The granular molded product according to the present invention has an average particle size in the range of 0.1 to 10.0 mm, preferably in the range of 0.1 to 5.0 mm, more preferably in the range of 0.5 to 5.0 mm, and particularly preferably in the range of 1.0 to 5.0 mm. Note that so long as the form is granular, the shape is not particularly limited, and granules may be irregularly shaped obtained by milling or granule molded products may be formed into spheres, cylinders, spindles, plates, different shapes, or the like. Note that the shape of these granules can be easily observed with an optical microscope or the like.

In particular, the granular composition according to the present invention preferably has 85 mass% or more of constituent particles thereof within the range of 0.1 to 10 mm, and more preferably within the range of 0.1 to 5 mm, with respect to the particle size distribution thereof, and preferably does not contain a large amount of fine or coarse particles outside of this range. Herein, in the granular compositions according to the present invention, if the average particle size is outside of the range described above, or if there are more particles outside the upper and lower limits of particle size than in the range described above with respect to the particle size distribution, there is a tendency that a substrate cannot be suitably sealed in the molding process.

For example, if there are too many compositions with a particle size smaller than the range above in the granular composition, compositions with smaller particle sizes tend to melt preferentially and do not melt uniformly during heat compression, resulting in failure to suitably seal the substrate. If there are too many compositions with particle sizes larger than the range above, compositions with small particle sizes are difficult to melt, and a granular resin composition may remain without melting in a composition melted during heat compression, and thus the substrate may not be suitably sealed. Note that the particle size distribution of the granular resin composition can be measured with a general particle size meter. The granular composition according to the present invention has a relatively large average particle size. Therefore, the granular composition may be sieved through sieves of various opening sizes, overlaid from the bottom in order of decreasing size, and calculation may be based on the mass of particles remaining on each sieve.

### [Melt Viscosity of Granular Composition]

The granular curable silicone composition of the present invention is solid with no fluidity or has plasticity at 25°C, but exhibits high fluidity at high temperatures. Specifically, the granular composition has a melt viscosity measured by a flow tester at 180°C of 200 Pa·s or less, more preferably 150 Pa·s or less, and particularly preferably 100 Pa·s or less, meets the compositional features described later, and may and preferably is a granular molded product where the aforementioned melt viscosity is in a range of 1 to 100 Pa·s or 1 to 50 Pa s. Note that with the composition of the invention described in Patent Document 3 and the like, particularly when the amount of component (C) is high, high fluidity as characterized by a melt viscosity of 200 Pa·s or less at 180°C cannot be achieved, and the gap-filling properties of the composition and the physical properties of the cured product may be insufficient.

### [Curable Silicone Composition]

The granular curable silicone composition of the present invention contains:
(A) an organopolysiloxane resin containing at least 20 mol% or more of siloxane units as expressed by RSiO_{3/2} (where R represents a monovalent hydrocarbon group) with respect to all siloxane units;
(B) a curing agent; and
(C) a functional inorganic filler,
is compositionally characterized in that the amount of component (C) is 400 to 3000 parts by mass relative to a total of 100 parts by mass of component (A) and component (B), and may contain another optional component so long as the aforementioned form and melt viscosity requirements are satisfied.

Component (A) is a main agent of the present composition, is an organopolysiloxane resin containing at least 20 mol% or more of a siloxane unit expressed by RSiO_{3/2} (where R represents a monovalent hydrocarbon group) with respect to all siloxane units, and is preferably an organopolysiloxane resin component having hot-melt properties on its own in order to provide the present composition with hot-melt properties. Furthermore, a reactive functional group is preferably provided in order to react with component (B) to be described later to form a cured product. Hydrosilylation reactions, radical reactions, condensation reactions, and the like are examples of curing reactions, but from the perspective of the curing rate of the resulting composition, the reaction is preferably either one of a hydrosilylation or radical reaction or both.

Component (A) is preferably a reactive functional group, and examples include hydrosilylation reactive groups and radical reactive groups. Examples of the hydrosilylation reactive group include vinyl groups, allyl groups, butenyl groups, pentenyl groups, hexenyl groups, heptenyl groups, octenyl groups, nonenyl groups, decenyl groups, undecenyl groups, dodecenyl groups, and other alkenyl groups having 2 to 20 carbon atoms, and silicon atom-bonded hydrogen atoms. An alkenyl group is preferable as the hydrosilylation reactive group. The alkenyl group may be linear or branched and is preferably a vinyl group or a hexenyl group. Component (A) preferably has at least two hydrosilylation reactive groups in one molecule.

Examples of groups bonded to a silicon atom other than the hydrosilylation reactive group in component (A) include methyl groups and other alkyl groups having 1 to 20 carbon atoms, halogen-substituted alkyl groups having 1 to 20 carbon atoms, phenyl groups and other aryl groups having 6 to 20 carbon atoms, halogen-substituted aryl groups having 6 to 20 carbon atoms, aralkyl groups having 7 to 20 carbon atoms, alkoxy groups, and hydroxyl groups. Methyl groups, phenyl groups, and hydroxyl groups are particularly preferable.

Furthermore, examples of radical reactive groups in component (A) include: methyl groups and other alkyl groups having 1 to 20 carbon atoms; vinyl groups, hexenyl groups, and other alkenyl groups having 2 to 20 carbon atoms; 3-acryloxypropyl groups, 4-acryloxybutyl groups, and other acrylic-containing groups; 3-methacryloxypropyl groups, 4-methacryloxybutyl groups, and other methacrylic-containing groups; and silicon atom-bonded hydrogen atoms. An alkenyl group is preferable as the radical reactive group. The alkenyl group may be linear or branched and is preferably a vinyl group or a hexenyl group. Component (A) preferably has at least two radical reactive groups in one molecule.

Examples of the group bonded to a silicon atom other than the radical reactive group in component (A) include halogen-substituted alkyl groups having 1 to 20 carbon atoms, aryl groups having 6 to 20 carbon atoms, halogen-substituted aryl groups having 6 to 20 carbon atoms, aralkyl groups having 7 to 20 carbon atoms, alkoxy groups, and hydroxyl groups, with the same groups as those described above being exemplified. In particular, a phenyl group and a hydroxyl group are preferable. In particular, in component (A), 10 mol% or more of all organic groups in a molecule is preferably an aryl group, and particularly preferably a phenyl group.

### [Component (A1)]

More specifically, at least some or all of component (A) is preferably
(A1) a hot-melt organopolysiloxane resin with a softening point of 30°C or higher, having a curing reactive functional group containing at least one carbon-carbon double bond in a molecule, and containing at least 20 mol% or more of a siloxane unit expressed by RSiO_{3/2} (where R represents a monovalent hydrocarbon group) with respect to all siloxane units. These components are described hereinafter.

Component (A1) has hot-melt properties by itself and has a curing reactive functional group containing at least one carbon-carbon double bond in a molecule, and thus is cured by the curing agent (B) to be described later. Such component (A1) is preferably a resinous organopolysiloxane.

In particular, component (A1) is a resinous organopolysiloxane having a carbon-carbon double bond group (hydrosilylation reactive group and/or radical reactive group) and is preferably a hot-melt resinous organopolysiloxane containing at least 20 mol% or more of a siloxane unit expressed by RSiO_{3/2} (where R represents a monovalent hydrocarbon group) with respect to all siloxane units and in which 10 mol% or more of a silicon atom-bonded organic group (A1-1) is an aryl group.

Examples of such component (A1) suitably include MT resins, MDT resins, MTQ resins, MDTQ resins, TD resins, TQ resins, and TDQ resins, which include an arbitrary combination of triorganosiloxy units (M unit) (organo groups are methyl groups only, methyl groups and vinyl groups or phenyl groups), diorganosiloxy units (D units) (organo groups are methyl groups only, methyl groups and vinyl groups or phenyl groups), monoorganosiloxy units (T units) (organo groups are methyl groups, vinyl groups, or phenyl groups), and siloxy units (Q units) and in which the amount of T units is at least 20 mol% or more of all siloxane units. Note that component (A1) preferably has at least two carbon-carbon double bond groups (hydrosilylation reactive groups and/or radical reactive groups) in a molecule, and 10 mol% or more of the all silicon atom-bonded organic groups in a molecule are an aryl group, and particularly a phenyl group.

Preferably, component (A1) includes an organopolysiloxane having hot-melt properties that is solid at room temperature but softens as the temperature increases, as expressed by the following:

(R¹₃SiO_{1/2})ₐ(R²₂SiO_{2/2})_{b}(R³SiO_{3/2})_{c}(SiO_{4/2})_{d}(R⁴O_{1/2)e}

In the formula, R¹, R², and R³ independently represent a monovalent hydrocarbon group having 1 to 10 carbon atoms. However, at least two of all Rs in one molecule must be an alkenyl group, and 70% or more of all alkenyl groups are preferably in R¹. R⁴ represents a hydrogen atom or an alkyl group having 1 to 10 carbon atoms; "a", "b", "c", "d" and "e" are numbers satisfying the following. (0.10 ≤ a ≤ 0.40, 0 ≤ b ≤ 0.50, 0.20 ≤ c ≤ 0.90, 0 ≤ d ≤ 0.20, 0 ≤ e ≤ 0.05, but a + b + c + d = 1)

Note that a preferred alkenyl group amount is 10 to 20 mol% of all R components. This is because if the amount of alkenyl groups is less than or equal to this range, a cured product exhibiting sufficient strength cannot be obtained, and if the amount is greater than or equal to this range, the cured product tends to be hard and brittle. Examples of alkenyl groups include vinyl groups, allyl groups, butenyl groups, pentenyl groups, and hexenyl groups. Furthermore, at least some of R¹, R², and R³ are preferably aryl groups, and more preferably phenyl groups, from the perspective of imparting suitable hot-melt properties to the present component. Other examples of monovalent hydrocarbon groups can include methyl groups and the like.

Furthermore, in the formula, "a" represents a number indicating the ratio of siloxane units expressed by the general formula: R¹₃SiO_{1/2}, and is a number satisfying 0.10 ≤ a ≤ 0.40, and preferably 0.10 ≤ a ≤ 0.30. This is because when the value of "a" is less than or equal to the upper limit of the aforementioned range, the hardness of the obtained cured product at room temperature is favorable. On the other hand, when the value of "a" is greater than or equal to the lower limit of the lower limit range, favorable hot-melt properties are achieved. Furthermore, in the formula, "b" represents a number indicating the ratio of siloxane units expressed by the general formula: R²₂SiO_{2/2}, and is a number satisfying 0 ≤ b ≤ 0.5. This is because when the value of "b" is less than or equal to the upper limit of the aforementioned range, favorable hot-melt properties can be achieved. Furthermore, in the formula, "c" represents a number indicating the ratio of siloxane units expressed by the general formula: R³SiO_{3/2}, and is a number satisfying 0.20 ≤ c ≤ 0.90, and preferably 0.25 ≤ c ≤ 0.85. This is because when the value of "c" is greater than or equal to the lower limit of the aforementioned range, the hardness of the obtained cured product at room temperature is favorable. On the other hand, when the value of "c" is less than or equal to the upper limit of the aforementioned range, mechanical strength of the obtained cured product is favorable. Furthermore, in the formula, "d" represents a number indicating the ratio of siloxane units expressed by the general formula: SiO_{4/2}, and is a number satisfying 0 ≤ d ≤ 0.20, and preferably 0 ≤ d ≤ 0.10. This is because when the value of "d" is less than or equal to the upper limit of the aforementioned range, the mechanical strength of the obtained cured product is favorable. Furthermore, "e" represents a number indicating the ratio of units expressed by the general formula: R²O_{1/2}, and is a number satisfying 0 ≤ e ≤ 0.05. This is because when the value of "e" is less than or equal to the aforementioned upper limit, the hardness of the obtained cured product at room temperature is favorable. Note that the sum of "a", "b", "c", and "d" in the formula is 1.

Component (A1) preferably exhibits hot-melt properties and, specifically, is non-fluid at 25°C. The melt viscosity at 150°C is 8000 Pa·s or less, preferably 5000 Pa·s or less, and more preferably in the range of 10 to 3000 Pa s. Non-fluid refers to not flowing in a no-load state, for example, the state of being less than the softening point measured by the softening point testing method in the ball and ring method of hot-melt adhesives specified in "Testing methods for the softening point of hot-melt adhesives" of JIS K 6863-1994. In other words, in order to be non-fluid at 25°C, the softening point must be higher than 25°C.

Component (A), and preferably component (A1), may be any organosiloxane resin of any molecular weight so long as the aforementioned structure and melting properties are exhibited. For example, an organopolysiloxane with the aforementioned structure may be used, in which a portion of the alkenyl group is cross-linked by component (B) described later, to raise the molecular weight, but from the perspective of the melting properties of the resulting composition, the molecular weight (Mw) thereof is preferably 20,000 g/mol or less.

Furthermore, component (A) is solid at room temperature as described above, and thus is preferably used as a resin in microparticle form or as a liquid mixture dissolved in another component required for the present composition from the perspective of ease of handling when mixed with other components.

If component (A) is in the form of microparticles, the particle size is not limited, but the average primary particle size is preferably within the range of 1 to 5,000 µm, within the range of 1 to 500 µm, within the range of 1 to 100 µm, within the range of 1 to 20 µm, or within the range of 1 to 10 µm. The average primary particle size can be determined, for example, by observation with an optical microscope or an SEM. The shape of the microparticulate component (A) is not limited, and examples include spherical shapes, spindle shapes, plate shapes, needle shapes, and irregular shapes, with a spherical shape or a true spherical shape being preferable for homogenous melting. In particular, by making component (A) into true spherical microparticles, the process of producing the present composition by powder mixing or melt kneading, as described later, can be efficiently performed.

When component (A) is microparticulated, the manufacturing method is not limited and a known method can be used. Note that when obtaining the microparticulate component (A), a hydrosilylation reaction catalyst, which is component (B) described later, may and is preferably microparticulated along with component (A).

Specific examples of the method for microparticulating component (A) include methods for pulverizing component (A), which is solid at room temperature, using a pulverizer and methods for directly microparticulating component (A) in the presence of a solvent. While not limited thereto, the pulverizer may be, for example, a roll mill, a ball mill, a jet mill, a turbo mill, or a planetary mill. Furthermore, component (A) may also be directly microparticulated in the presence of a solvent, for example, by spraying with a spray dryer, or by a twin-shaft kneading machine or belt dryer. When component (A) is microparticulated, true spherical hot-melt organopolysiloxane resin microparticles obtained by spraying with a spray dryer are preferably used.

Component (A) having a spherical shape and an average primary particle size of 1 to 500 µm can be manufactured by the use of a spray dryer or the like. Note that the heating and drying temperature of the spray dryer needs to be appropriately set based on the heat resistance and the like of the organopolysiloxane resin microparticles. Note that in order to prevent secondary aggregation of the organopolysiloxane resin microparticles, the temperature of the organopolysiloxane resin microparticles is preferably controlled below the glass transition temperature thereof. The organopolysiloxane resin microparticles thus obtained can be recovered by a cyclone, a bag filter, or the like.

In order to obtain a homogenous component (A), a solvent may be used in the aforementioned step within the range that does not inhibit the curing reaction. Examples of solvents include, but are not limited to: aliphatic hydrocarbons such as n-hexane, cyclohexane, n-heptane, and the like; aromatic hydrocarbons such as toluene, xylene, mesitylene, and the like; ethers such as tetrahydrofuran, dipropyl ether, and the like; silicones such as hexamethyldisiloxane, octamethyltrisiloxane, decamethyltetrasiloxane, and the like; esters such as ethyl acetate, butyl acetate, propylene glycol monomethyl ether, and the like; and ketones such as acetone, methyl ethyl ketone, methyl isobutyl ketone, and the like.

Furthermore, when a silicone compound that is liquid at room temperature is used as all or part of component (B) described later, component (A) may be dissolved in part of component (B). Liquid silicone compounds exhibit a certain degree of mutual solubility with component (A), and can dissolve component (A) by adding, for example, 10 to 50 parts by mass of some of component (B) to 100 parts by mass of component (A). By liquefying component (A), the present composition described later can be efficiently produced by powder mixing or melt kneading.

### [Component (B)]

Component (B) is a curing agent for curing component (A) and is not limited so long as component (A) can be cured. When component (A) has an alkenyl group, component (B) is an organohydrogenpolysiloxane having at least two silicon atom-bonded hydrogen atoms in one molecule and a hydrosilylation reaction catalyst. Moreover, when component (A) contains an alkenyl group and contains a hydrosilylation reaction catalyst, component (B) may only be an organopolysiloxane having at least two silicon atom-bonded hydrogen atoms in one molecule. However, a hydrosilylation reaction catalyst may be used in combination. Furthermore, when component (A) has an alkenyl group, component (B) may be an organic peroxide, and an organopolysiloxane having at least two silicon atom-bonded hydrogen atoms may be used in combination in one molecule. On the other hand, when component (A) has a silicon atom-bonded hydrogen atom, component (B) may be an organopolysiloxane having at least two alkenyl groups in one molecule and a hydrosilylation reaction catalyst. Moreover, when component (A) has a silicon atom-bonded hydrogen atom and contains a hydrosilylation reaction catalyst, component (B) may be an organopolysiloxane having at least two alkenyl groups in one molecule, and a hydrosilylation reaction catalyst may be used in combination. Furthermore, if component (A) has a reactive silanol group, a condensation catalyst may be included. Note that when a condensation reaction is used as the curing reaction, a known thermal base generator or the like may be used as part of component (B).

As described above, component (B) contains a curing catalyst tailored to a selected reaction system, but the granular composition according to the present invention is preferably homogenized by melt kneading or the like in the temperature range of 50 to 150°C, and preferably 50 to 120°C, for the purpose of compositional homogenization, and then granulated. Therefore, from the perspective of inhibiting unintended curing reactions and maintaining the curing reactivity of the granular curable silicone composition according to the present invention, component (B) is preferably a curing agent that is inactive unless subjected to a certain thermal energy stimulation. Specifically, component (B) is particularly preferably a curing agent that does not dissolve (i.e., incompatible) with another component in the present composition at room temperature and contains a curing reaction catalyst that is active in the composition by thermal energy stimulation of 80°C or higher, preferably 100°C or higher, and more preferably 120°C or higher, and is a curing catalyst that does not initiate a curing reaction below these temperatures. For example, some or all of the curing agent can be dissolved in another component including component (A) in advance and then mixed into the present composition. However, such a curing agent dissolves in other components at room temperature and diffuses into the system. Therefore, the curing reaction tends to proceed at an unintended timing and the overall storage stability and controllability of curing reactivity as a whole composition may be inferior.

More specifically, component (B) preferably contains one or more types of curing agents selected from: (B1) organic peroxides with a half-life of 10 hours at a temperature of 80°C or higher; and (B2) hydrosilylation reaction catalyst-containing thermoplastic resin microparticles containing a thermoplastic resin with a softening point or glass transition point of 80°C or higher, or is preferably these curing agents. This is because the use of components (B1) or (B2) as a curing agent effectively suppresses unintended curing reactions even when the composition is homogenized and granulated by a process involving heating such as melt kneading or the like, and thus the resulting granular composition has both favorable hot-melt properties and curing properties at high temperatures.

Component (B1) is a curing agent suitable for use when a radical reaction is used as the curing reaction in the present composition, and is preferably an organic peroxide with a half-life of 10 hours at a temperature of 90°C or higher or 95°C or higher. Examples of such an organic peroxide include dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

While not limited thereto, the amount of organic peroxide is preferably within the range of 0.05 to 10 parts by mass or within the range of 0.10 to 5.0 parts by mass, with respect to 100 parts by mass of component (A).

Component (B2) is part of the curing agent suitably used when a hydrosilylation reaction is used as the curing reaction in the present composition, and may be either microparticles in which the platinum-based catalyst is dissolved or dispersed in the thermoplastic resin, or microcapsule microparticles with a structure in which the platinum-based catalyst is included as a core within a thermoplastic resin shell. Examples of the platinum-based catalyst include platinum black, platinum-supported carbon fine powders, platinum-supported silica fine powders, platinum chlorides, alcohol-modified platinum chlorides, platinum olefin complexes, and platinum alkenylsiloxane complexes. The thermoplastic resin used for component (B2) is not particularly limited so long as the platinum-based catalyst does not substantially permeate at least during production and storage of the present composition and is not substantially soluble in a main component organopolysiloxane of the present composition. However, the softening point or glass transition point of the thermoplastic resin is preferably 80°C or higher, and more preferably 120°C or higher. Specifically, silicone resin, polysilane resin, epoxy resin, acrylic resin, methylcellulose resin, and polycarbonate resin can be suitably used, but solubility in the present composition must be low. The softening point is the temperature at which a resin begins to flow under its own weight or by its own surface tension, and can be measured by a method of observing pulverized particles under a microscope while increasing the temperature at a constant rate. Furthermore, the glass transition point can be measured by a DSC (differential scanning calorimeter). In the present invention, either the softening point or the glass transition point is preferably 120°C or higher. This is because if the softening point or glass transition point of the thermoplastic resin is less than 120°C, there is a concern that the platinum component will begin to elute during the homogeneous mixing step of the present composition, which is described later. Furthermore, the average particle size of the thermoplastic microparticles containing the platinum-based catalyst is not limited, but is preferably in the range of 0.1 to 500 µm, and more preferably in the range of 0.3 to 100 µm. This is because preparing thermoplastic resin microparticles containing a platinum-based catalyst with an average particle size that is less than the lower limit of the range above is difficult. On the other hand, dispersibility in the curable silicone resin composition is reduced if the average particle size exceeds the upper limit of the range above.

The method for preparing the thermoplastic resin microparticles containing the platinum-based catalyst is not limited, and examples include conventionally known chemical methods such as interfacial polymerization, in-situ polymerization, and the like, and physical and mechanical methods such as coacervation, drying in liquid, and the like. The drying in liquid method and vapor phase drying method are particularly desirable because obtaining microcapsule microparticles with a narrow particle size distribution is relatively easy. The microparticles obtained by these methods can be used as is, but it is desirable to wash the microparticles with an appropriate cleaning solvent to remove the platinum-based catalyst attached to the surface, in order to obtain a curable silicone resin composition with excellent storage stability. Herein, an appropriate cleaning solvent does not dissolve the thermoplastic resin, but has a property of dissolving the platinum-based catalyst. Examples of such cleaning solvents include methyl alcohol, ethyl alcohol, and other alcohols, hexamethyldisiloxane and other low molecular weight organopolysiloxanes, and the like. The ratio of hydrosilylation reaction catalyst to thermoplastic resin is not particularly limited, because the value varies greatly depending on the method for manufacturing a granular product, but the ratio is preferably such that the amount of platinum-based catalyst to thermoplastic resin is 0.01 mass% or more. This is because if the amount of platinum-based catalyst is less than 0.01 mass%, the physical properties of the cured product of the present composition will be impaired unless a large amount of thermoplastic resin microparticles containing the platinum-based catalyst is included in the present composition.

The amount of the hydrosilylation reaction catalyst added is preferably an amount in which the metal atoms are within the range of 0.01 to 500 ppm, 0.01 to 100 ppm, or 0.01 to 50 ppm in mass units with respect to the entire composition.

When a hydrosilylation reaction is used as the curing reaction of the present composition, component (B) may contain, in addition to the hydrosilylation reaction catalyst (preferably component (B2) described above), an organosiloxane component other than component (A) as a hydrosilylation cross-linking component, and preferably contains (B3) an organohydrogenpolysiloxane. The structure thereof is not particularly limited and can be linear, branched, cyclic or resinous. However, from the perspective of excellent curing properties of the resulting composition, an organohydrogenpolysiloxane having a hydrogen diorganosiloxy unit expressed by HR₂SiO_{1/2} (M^{H} unit, where R independently represents a monovalent organic group) at an end is preferable.

The organohydrogenpolysiloxane serving as the hydrosilylation cross-linking component (B3) is more specifically preferably an organopolysiloxane in which 20 to 70 mol% of all silicon atom-bonded organic groups are phenyl groups. When the amount of phenyl groups is greater than or equal to the lower limit of the range above, the resulting cured product has favorable mechanical strength at high temperatures, while when the amount of phenyl groups is less than or equal to the upper limit of the range above, the resulting cured product has favorable mechanical strength.

Two or more silicon atom-bonded hydrogen atoms in component (B3) are present in one molecule, which provides sufficient cross-linking reactivity for curing and favorable hardness of the resulting cured product. Examples of the silicon atom-bonded organic groups in component (B) include monovalent hydrocarbon groups having no unsaturated aliphatic bonds, such as: methyl groups, ethyl groups, propyl groups, butyl groups, pentyl groups, hexyl groups, heptyl groups, cyclopentyl groups, cyclohexyl groups, cycloheptyl groups, and other alkyl groups; phenyl groups, tolyl groups, xylyl groups, and other aryl groups; benzyl groups, phenethyl groups, and other aralkyl groups; and the like. Of these, phenyl groups and alkyl groups having 1 to 6 carbon atoms are preferred.

Two examples of such component (B3) include:
(B3-1) a linear organopolysiloxane expressed by the general formula:

   HR⁴₂SiO(R⁴₂SiO)ₙSiR⁴₂H,

   and
(B3-2) a branched organopolysiloxane expressed by the average unit formula:

   (R⁴SiO_{3/2})ₚ(R⁴₂SiO_{2/2})_{q}(HR⁴₂SiO_{1/2})ᵣ(SiO_{4/2})ₛ(XO_{1/2})ₜ.

A combination of these two components (B3) is preferably used as the hydrosilylation cross-linking component.

In the formula, R⁴ represents the same or different phenyl groups or alkyl groups having 1 to 6 carbon atoms. Examples of alkyl groups of R⁴ include methyl groups, ethyl groups, propyl groups, butyl groups, pentyl groups, hexyl groups, cyclopentyl groups, and cyclohexyl groups. Note that of all R⁴s, the amount of phenyl groups is in the range of 30 to 70 mol%.

Furthermore, in the formula, "n" represents an integer in the range of 5 to 1,000. In the formula, "p" represents a positive number, "q" represents 0 or a positive number, "r" represents a positive number, "s" represents 0 or a positive number, and "t" represents 0 or a positive number. Moreover, "q"/"p" is a number in the range of 0 to 10, "r"/"p" is a number in the range of 0.1 to 5, "s"/("p"+"q"+"r"+"s") is a number in the range of 0 to 0.3, and "t"/("p"+"q"+"r"+"s") is a number in the range of 0 to 0.4.

In such component (B3), a combination of component (B3-1) and component (B3-2) is preferable from the perspective of ease of control of the curing rate of the composition and the cross-linking density of the resulting cured product. A suitable ratio of the two components is in the range of (B3-1):(B3-2) = 0.05 to 0.6 : 0.4 to 0.95 per alkenyl group of the entire composition, preferably in the range of 0.05 to 0.5 : 0.5 to 0.95, and more preferably in the range of 0.05 to 0.4 : 0.5 to 0.95.

When the organohydrogenpolysiloxane above is used as part of component (B), the amount thereof is not limited. However, in order to cure the present composition, the amount is preferably in the range of 0.5 to 20 mols or 1.0 to 10 mols of silicon atom-bonded hydrogen atoms per mol of alkenyl groups in the present composition. Note that the amount of the hydrosilylation reaction catalyst used is as described above.

In the composition according to the present invention, a particularly preferable component (B) contains components (B2), (B3-1) and (B3-2) described above, and the composition as a whole effectively suppresses side reactions and unintended curing reactions, and has the advantage of excellent hot-melt and heat curing properties at high temperatures.

### [Component (C)]

Component (C) of the present invention is an inorganic filler and can provide a curable silicone composition which cures to impart a cured product with excellent hardness and toughness from room temperature to high temperatures. In the present invention, low melt viscosity suitable for sealing, transfer molding, compression molding, and press molding can be achieved even when component (C) is added in the range of 400 to 3000 parts by mass with respect to a total of 100 parts by mass of component (A) and component (B), and blending is possible in the range of 500 to 3000 parts by mass, or in the range of 800 to 3000 parts by mass.

From the perspective of achieving a low average linear expansion coefficient with respect to the cured product of the granular curable silicone composition according to the present invention, the amount of component (C) is preferably 50 vol% or more of the total composition, more preferably 60 vol% or more, even more preferably 70 vol% or more, and particularly preferably in the range of 80 to 95 vol%.

In order to achieve the blending amount above and to achieve a low average linear expansion coefficient for the resulting cured product, component (C) is preferably treated with a specific surface treating agent, and particularly a surface treating agent of 0.1 to 2.0 mass%, 0.1 to 1.0 mass%, or 0.2 to 0.8 mass% of the total mass of component (C). Treating component (C) with a surface treating agent at the treatment amount described above enables the advantage that component (C) can be stably blended at a high vol% in the composition. In addition, the surface treatment method is optional, with a desired method such as a uniform mixing method using mechanical force (dry), a wet mixing method using a solvent, or the like capable of being used.

Examples of these surface treating agents include methylhydrogenpolysiloxane, silicone resins, metal soaps, silane coupling agents, perfluoroalkylsilane, perfluoroalkylphosphate ester salts, and other fluorine compounds, and the like. However, silicone-based surface treating agents described below are particularly preferable. Note that if a silane-based surface treating agent, such as methyltrimethoxysilane, phenyltrimethoxysilane, or the like, is selected as the surface treating agent, the hot-melt properties of the entire composition may be impaired, and stable blending of component (C) at the vol% amount described above may not be feasible. Furthermore, when alkyltrialkoxysilane having a long chain alkyl group, such as an octyl group or the like, is selected as the surface treating agent, the hot-melt properties of the composition and the blending stability of component (C) tend to be retained but this may lead to deterioration of the strength of the cured product obtained by curing the composition of the present invention and may lead to cracks or molding defects.

Herein, examples of organic silicon compounds as surface treating agents include silanes, silazanes, siloxanes, and other low molecular weight organic silicon compounds, along with organic silicon polymers or oligomers such as polysiloxanes, polycarbosiloxanes, and the like. A so-called silane coupling agent is an example of a preferred silane. Typical examples of the silane coupling agents include alkyltrialkoxysilanes (such as methyltrimethoxysilane, vinyltrimethoxysilane, hexyltrimethoxysilane, octyltrimethoxysilane, decyltrimethoxysilane, and the like) and trialkoxysilanes containing an organic functional group (such as glycidoxypropyltrimethoxysilane, epoxycyclohexyl ethyltrimethoxysilane, methacryloxypropyltrimethoxysilane, aminopropyltrimethoxysilane, and the like). Examples of preferred siloxanes and polysiloxanes include hexamethyldisiloxanes, 1,3-dihexyl-tetramethyldisiloxanes, trialkoxysilyl single-terminated polydimethylsiloxanes, trialkoxysilyl single-terminated dimethylvinyl single-terminated polydimethylsiloxanes, trialkoxysilyl single-terminated organic functional group single-terminated polydimethylsiloxanes, trialkoxysilyl doubly-terminated polydimethylsiloxanes, organic functional group doubly-terminated polydimethylsiloxanes, and the like. When a siloxane is used, the number "n" of siloxane bonds is preferably within the range of 2 to 150. Examples of preferred silazanes include hexamethyldisilazanes, 1,3-dihexyl-tetramethyldisilazanes, and the like. A polymer having a Si-C-C-Si bond in a polymer main chain is an example of a preferred polycarbosiloxane.

An example of a particularly suitable silicone-based surface treating agent is a silicone-based surface treating agent having at least one polysiloxane structure and a hydrolyzable silyl group in a molecule. Most suitably, the use of a silicone-based surface treating agent having at least one polysiloxane structure and a hydrolyzable silyl group in a molecule is preferable, and examples include organopolysiloxanes having a linear alkoxysilyl end, which is expressed by:

Structural formula (1): R'ₙ(RO)₃₋ₙSiO-(R'₂SiO)ₘ-SiR'ₙ (RO)₃₋ₙ, or

Structural formula (2): R'₃SiO-(R'₂SiO)ₘ-SiR'ₙ(RO)₃₋ₙ.

In the formulas, R represents a hydrogen atom or an alkyl group having 1 to 3 carbon atoms (= methyl group, ethyl group, or propyl group), while each R' independently represents an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, with the same groups as those described above being exemplified. "n" is a number in the range of 0 to 2, while "m" is a number in the range of 2 to 200 and may be a number in the range of 2 to 150.

Such component (C) is preferably at least one filler which does not have a softening point or does not soften at or below the softening point of component (A) and may be a component which improves the handling workability of the present composition, in addition to imparting mechanical properties and other properties to the cured product of the present composition. Examples of component (C) include inorganic fillers, organic fillers, and mixtures thereof, with inorganic fillers being preferable. Examples of the inorganic filler include reinforcing fillers, white pigments, thermally conductive fillers, electrically conductive fillers, phosphors, and mixtures of at least two thereof, and in particular, 40% or more of the total component (C) preferably contains a reinforcing filler with an average particle size of 10.0 µm or more in order to achieve a high vol% filling amount. Examples of the organic filler include silicone resin fillers, fluorine resin fillers, and polybutadiene resin fillers. Note that the shape of these fillers is not particularly limited and may be spherical, spindle-shaped, flat, needle-shaped, plate-shaped, amorphous, or the like.

The present composition imparts mechanical strength and improves protective and adhesive properties in the cured product when used in a sealing agent, protective agent, adhesive, and light reflective material and the like. Therefore, a reinforcing filler is preferably added as component (E). Examples of the reinforcing filler include fumed silica, precipitable silica, fused silica, calcined silica, fumed titanium dioxide, quartz, calcium carbonate, silica earth, aluminum oxide, aluminum hydroxide, zinc oxide, zinc carbonate, glass beads, glass powder, talc, clay and mica, kaolin, silicon carbide, silicon nitride, aluminum nitride, carbon black, graphite, titanium dioxide, calcium sulfate, barium carbonate, magnesium carbonate, magnesium sulfate, barium sulfate, cellulose, aramid, and the like. Furthermore, these reinforcing fillers may also be surface treated with: methyltrimethoxysilane or other organoalkoxysilane; trimethylchlorosilane or other organohalosilane; hexamethyldisilazane or other organosilazane; dimethylsiloxane oligomers blocked with an α,ω-silanol group, methylphenylsiloxane oligomers blocked with an α,ω-silanol group, methylvinylsiloxane oligomers blocked with an α,ω-silanol group, or other siloxane oligomers; or the like. Furthermore, examples of the reinforcing filler that may be used include: calcium metasilicate, potassium titanate, magnesium sulfate, sepiolite, zonolite, aluminum borate, rock wool, glass fiber, carbon fiber, asbestos fiber, metal fiber, wollastonite, attapulgite, sepiolite, aluminum borate whisker, potassium titanate fiber, calcium carbonate whisker, titanium oxide whisker, ceramic fiber, and other fibrous inorganic fillers; and aramid fiber, polyimide fiber, polyparaphenylene benzobisoxazole fiber, and other fibrous fillers. Furthermore, the following may also be used: talc, kaolin clay, calcium carbonate, zinc oxide, calcium silicate hydrate, mica, glass flakes, glass powder, magnesium carbonate, silica, titanium oxide, alumina, aluminum hydroxide, magnesium hydroxide, barium sulfate, calcium sulfate, calcium sulfite, zinc borate, barium metaborate, aluminum borate, calcium borate, sodium borate, aluminum nitride, boron nitride, silicon nitride, pulverized products of the fibrous fillers above, and other plate-shaped fillers or granular fillers.

In particular, from the perspective of providing the present composition with the hardness of a cured product at room temperature to high temperatures, component (C) is preferably spherical silica or aluminum oxide (alumina) having an average particle size of 10.0 µm or more.

Component (C) may contain silicone microparticles that do not have hot-melt properties such that stress relaxation properties and the like can be improved or adjusted as desired. While silicone microparticles include nonreactive silicone resin microparticles and silicone elastomer microparticles, silicone elastomer microparticles are suitably exemplified from the perspective of improving flexibility or stress relaxation properties.

The silicone elastomer microparticles are a cross-linked product of linear diorganopolysiloxane primarily including a diorganosiloxy unit (D units). The silicone elastomer microparticles can be prepared by a cross-linking reaction of diorganopolysiloxane by a hydrosilylation reaction, a condensation reaction of a silanol group, or the like. In particular, the silicone elastomer microparticles can be suitably obtained by a cross-linking reaction of an organohydrogenpolysiloxane having a silicon-bonded hydrogen atom at a side chain or an end with a diorganopolysiloxane having an unsaturated hydrocarbon group, such as an alkenyl group or the like, at a side chain or an end under a hydrosilylation reaction catalyst. The silicone elastomer microparticles may have various shapes such as spherical, flat, and irregular shapes, but are preferably spherical from the perspective of dispersibility, with true spherical being particularly preferable. Examples of commercially available products of such silicone elastomer microparticles (C) include "Torefil-E series" and "EP Powder series" manufactured by Dow Corning Toray Company, Ltd., "KMP series" manufactured by Shin-Etsu Chemical Co., Ltd., and the like. Note that the silicone elastomer microparticles may be subjected to surface treatment.
Furthermore, the elastomer microparticles may be acrylnitrile butadiene rubber, isoprene, styrene butadiene rubber, ethylene propylene rubber, or the like.

Furthermore, when the present composition is used as a wavelength conversion material for an LED, a phosphor may be added as component (C) to convert the emission wavelength from the optical semiconductor element. The phosphor is not particularly limited, and examples thereof include yellow, red, green, and blue light phosphors and the like, which include oxide phosphors, oxynitride phosphors, nitride phosphors, sulfide phosphors, oxysulfide phosphors, and the like and are widely used in light emitting diodes (LED). Examples of the oxide phosphors include: yttrium, aluminum, and garnet-type YAG green to yellow light phosphors containing cerium ions; terbium, aluminum, and garnet-type TAG yellow light phosphors containing cerium ions; and silicate green to yellow light phosphors containing cerium or europium ions. Furthermore, examples of oxynitride phosphors include silicon, aluminum, oxygen, and nitrogen type SiAlON red to green light phosphors containing europium ions. Examples of nitride phosphors include calcium, strontium, aluminum, silicon, and nitrogen type CASN red light phosphors containing europium ions. Examples of sulfide phosphors include ZnS green light phosphors containing copper ions or aluminum ions. Examples of oxysulfide phosphors include Y₂O₂S red light phosphors containing europium ions. In the present composition, two or more of these phosphors may be used in combination.

Furthermore, the present composition may contain a thermally conductive filler or an electrically conductive filler to impart thermal or electrical conductivity to the cured product. Examples of the thermally conductive filler or the electrically conductive filler include: metal fine powders such as gold, silver, nickel, copper, aluminum, tin, lead, zinc, bismuth, antimony, and the like; fine powders obtained by depositing or plating a metal such as gold, silver, nickel, copper or the like on the surface of a fine powder of ceramic, glass, quartz, organic resin or the like; metal compounds such as aluminum oxide, magnesium oxide, aluminum nitride, boron nitride, zinc oxide, or the like; graphite; and mixtures of two or more thereof. When electrical insulation is required for the present composition, a metal oxide-based powder or a metal nitride-based powder is preferable, and an aluminum oxide powder, a zinc oxide powder, or an aluminum nitride powder is particularly preferable.

Furthermore, the present composition may contain a coloring agent to provide the cured product with color. Examples of such coloring agents include black titanium oxide, pitch (residue from distillation of tar obtained by dry distillation of organic substances such as oil, coal, wood, and the like), carbon black, acetylene black, red iron oxide, and the like. Acetylene black can be suitably used when reducing the amount of metal impurities. Furthermore, black dyes may be included, such as anthraquinone dyes (sometimes referred to as "anthraquinone"), azine dyes, azo dyes, disazo dyes, chromium complex dyes, and the like, and when used in combination with a yellow dye, such as methine dyes, disazo dyes, azocobalt complex dyes, azochrome complex dyes, and the like, the color can approach that of a black pigment.

Furthermore, the present composition may optionally contain a thermal expansive filler. The inclusion of the thermal expansive filler may improve the volume expansion rate of the composition according to the present invention and reduce uneven distribution of the composition. The thermal expansive filler above is preferably a core-shell structure and contains a volatile expansion agent inside the shell of the core-shell structure. Herein, volatile expansion agent refers to a substance that generates gas at a temperature at or below the softening point of the shell, and the thermal expansive filler has a structure in which the volatile expansion agent is encapsulated as a core agent inside a gas barrier shell. Therefore, heat can cause the volatile expansion agent to be gaseous and the shell to soften and expand. Such components are exemplified in, for example, Japanese Unexamined Patent Application 2020-084094 and the like, and are available as FN-100SSD and FN-80GSD manufactured by Matsumoto Yushi-Seiyaku Co., Ltd., and the like.

When the cured product obtained by curing the present composition is used for powder magnetic needles, coils, electromagnetic shielding materials, and other magnetic members, the cured product may contain magnetic particles as component (C). Such magnetic particles contain one or more elements selected from the group consisting of Fe, Cr, Co, Ni, Ag and Mn. In particular, soft magnetic particles may include magnetic particles made of iron (Fe), Fe-Si alloy, Fe-Al alloy, Fe-Ni alloy, Fe-Co alloy, Fe-Si-Al alloy, Fe-Si-Cr alloy, Fe-Cr alloy, carbonyl iron, stainless steel, and the like. From the perspective of availability, magnetic particles may be made of carbonyl iron. Similar to the inorganic fillers mentioned earlier, these magnetic particles may be surface treated with a silane compound, titanate compound, aluminate compound, or partial hydrolyzate thereof, which may prevent deactivation of the curing catalyst or cross-linking agent and improve storage stability. In addition, these magnetic particles may have a surface coating layer containing a siloxane polymer, for example, by a method described in Japanese Unexamined Patent Application 2021-036013, and the like.

Furthermore, the present composition may contain hot-melt microparticles (component D), a curing retarder (component E) or an adhesion imparting agent (component F) other than component (A) as an optional component, so long as the object of the present invention is not impaired.

Component (D) consists of hot-melt microparticles other than component (A), and is exemplified by one or more types selected from various hot-melt synthetic resins, waxes, fatty acid metal salts, and the like. The wax component exhibits low kinematic viscosity at high temperatures (150°C) and forms a melt with excellent fluidity. Furthermore, by combining components (A) to (C) described above, the wax component in the melt containing the present composition spreads quickly throughout the composition at high temperatures, thereby lowering the viscosity of the base material surface to which the molten composition is applied and of the composition as a whole, rapidly lowering the surface friction of the base material and the molten composition and significantly increasing the fluidity of the composition as a whole. Therefore, the viscosity and fluidity of the molten composition can be greatly improved by adding only a very small amount to the total amount of other components.

The wax components may be paraffin and other petroleum waxes, carnaba wax and other natural waxes, or montanate ester wax and other synthetic waxes, so long as the wax components satisfy the aforementioned conditions of dropping point and kinematic viscosity when melted. However, from the perspective of the technical effect of the present invention, the wax component is preferably a hot-melt component containing a fatty acid metal salt or an erythritol derivative fatty acid ester, and particularly preferably metal salts of higher fatty acids such as stearic acid, palmitic acid, oleic acid, isononanoic acid and the like, or pentaerythritol tetrastearate, dipentaerythritol adipic acid stearate, glycerintri-18-hydroxystearate, or pentaerythritol fulstearate. Herein, the types of fatty acid metal salts described above are also not particularly limited, and preferable examples include: alkali metal salts such as lithium, sodium, potassium, and the like; alkali earth metal salts such as magnesium, calcium, barium, and the like; and zinc salts.

Particularly preferably as the wax component are fatty acid metal salts and erythritol derivatives having a free fatty acid amount of 5.0% or less, and particularly preferably 4.0% or less, and 0.05 to 3.5%. Examples of such a component include at least one or more stearic acid metal salts. Specifically, the use of a hot-melt component with a melting point of 150°C or lower is most preferable, which is selected from calcium stearate (melting point: 150°C), zinc stearate (melting point: 120°C), and magnesium stearate (melting point: 130°C), pentaerythritol tetrastearate (melting point: 60 to 70°C), pentaerythritol adipate stearate (melting point: 55 to 61°C), pentaerythritol fulstearate (melting point: 62 to 67°C), and the like.

With regard to the amount of the wax component used, assuming that the overall composition is 100 parts by mass, the amount of the component is in the range of 0.01 to 5.0 parts by mass and may be 0.01 to 3.5 parts by mass or 0.01 to 3.0 parts by mass. If the amount of the wax component used exceeds the upper limit above, the adhesive properties and mechanical strength of the cured product obtained from the granular curable silicone composition of the present invention may be insufficient. If the amount used is less than the lower limit above, sufficient fluidity while heating and melting may not be achieved.

Component (E) is a curing retarder, which may effectively suppress side reactions, particularly when the present composition is cured by a hydrosilylation reaction, and may further improve the storage stability of the granular composition according to the present invention, the usable time when heated and melted, and the like.

The available curing retarders are not particularly limited in structure and type and can be selected from known hydrosilylation reaction inhibitors. Examples thereof include: 2-methyl-3-butyn-2-ol, 3,5-dimethyl-1-hexyn-3-ol, 2-phenyl-3-butyn-2-ol, 1-ethynyl-1-cyclohexanol, and other alkyne alcohols; 3-methyl-3-penten-1-yne, 3,5-dimethyl-3-hexen-1-yne, and other enyne compounds; tetramethyltetravinylcyclotetrasiloxane, tetramethyltetrahexenylcyclotetrasiloxane, and other alkenyl group-containing low molecular weight siloxanes; methyl-tris(1,1-dimethyl-2-propynyloxy)silane, vinyl-tris(1,1-dimethylpropynyloxy)silane, and other alkynyloxysilanes; and bis(alkynyloxysilyl)alkanes expressed by the following formula.
Expressed by 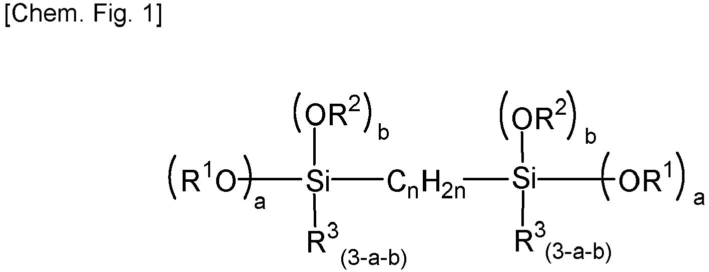 (where R¹ independently represents an alkynyl group having 5 to 12 carbon atoms, R² independently represents an alkyl group having 1 to 3 carbon atoms or a hydrogen atom, R³ independently represents an alkyl group having 1 to 3 carbon atoms, "a" independently represents 1, 2, or 3, "b" independently represents 0, 1, or 2, and "a + b" is 2 or 3, where at least one of "b" is 1 or 2, and "n" represents an integer from 2 to 20).

In the formula, R¹ preferably represents an alkynyl group expressed by the formula: 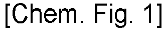 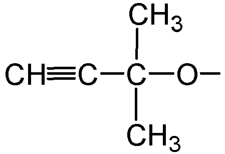 an alkynyl group expressed by the formula: 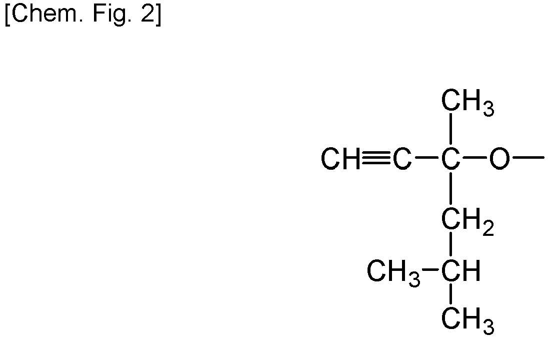 and an alkynyl group expressed by the formula:

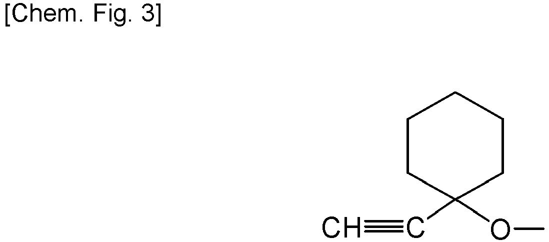

A compound with a boiling point of 200°C or higher under atmospheric pressure is particularly preferably used as component (E). This is because the granular composition according to the present invention can be granulated through a process involving heating, such as melt kneading and the like of the composition, from the perspective of compositional homogeneity, but if a compound with a low boiling point is used as a curing retarder, some or all of the curing retarder may volatilize during the melt kneading process required for granulation. Moreover, the curing retardant effect on the final granular curable silicone composition may not be achieved. Note that methyl-tris(1,1-dimethyl-2-propynyloxy)silane and bis(alkynyloxysilyl)alkanes have boiling points under atmospheric pressure of 245°C and 300°C or higher, respectively, and thus are preferred examples of component (E).

The amount of component (E) used is arbitrary, but is preferably in the range of 1 to 10,000 ppm in mass units with respect to the entire composition.

Component (F) is an adhesion imparting agent, and examples include organic silicon compounds having at least one alkoxy group bonded to a silicon atom in one molecule. Examples of this alkoxy group include methoxy groups, ethoxy groups, propoxy groups, butoxy groups, and methoxyethoxy groups, with methoxy groups being particularly preferable. Furthermore, examples of groups bonded to a silicon atom other than the alkoxy groups in the organic silicon compound include: halogen-substituted or unsubstituted monovalent hydrocarbon groups such as alkyl groups, alkenyl groups, aryl groups, aralkyl groups, halogenated alkyl groups, and the like; glycidoxyalkyl groups such as 3-glycidoxypropyl groups, 4-glycidoxybutyl groups, and the like; epoxycyclohexylalkyl groups such as 2-(3,4-epoxycyclohexyl)ethyl groups, 3-(3,4-epoxycyclohexyl)propyl groups, and the like; epoxyalkyl groups such as 3,4-epoxybutyl groups, 7,8-epoxyoctyl groups, and the like; acrylic group-containing monovalent organic groups such as 3-methacryloxypropyl groups and the like; and hydrogen atoms. This organic silicon compound preferably has a group that may react with an alkenyl group or a silicon atom-bonded hydrogen atom in the present composition, and specifically, preferably has a silicon atom-bonded hydrogen atom or an alkenyl group. Furthermore, favorable adhesion can be imparted to various base materials, and thus this organic silicon compound preferably has at least one epoxy group-containing monovalent organic group in one molecule. Examples of such organic silicon compounds include organosilane compounds, organosiloxane oligomers, and alkyl silicates. Examples of molecular structures of this organosiloxane oligomer or alkyl silicate include linear structures, partially branched linear structures, branched structures, cyclic structures, and network structures, of which linear structures, branched structures, and network structures are particularly preferable. Examples of the organic silicon compound include: silane compounds such as 3-glycidoxypropyltrimethoxysilane, 2-(3,4-epoxycyclohexyl) ethyltrimethoxysilane, 3-methacryloxypropyltrimethoxysilane, and the like; siloxane compounds having at least one silicon atom-bonded alkenyl group or silicon atom-bonded hydrogen atom and one silicon atom-bonded alkoxy group in one molecule; mixtures of a silane compound or siloxane compound having at least one silicon atom-bonded alkoxy group and a siloxane compound having at least one silicon atom-bonded hydroxy group and one silicon atom-bonded alkenyl group in one molecule; reaction mixtures of amino group-containing organoalkoxysilane and epoxy group-containing organoalkoxysilane; organic compounds having at least two alkoxysilyl groups in one molecule and containing bonds other than a silicon-oxygen bond between these silyl groups; epoxy group-containing silanes expressed by the general formula:

R^{a}ₙSi(OR^{b})₄₋ₙ

(where R^{a} represents a monovalent epoxy group-containing organic group, and R^{b} represents a hydrogen atom or an alkyl group having 1 to 6 carbon atoms. n represents a number within the range of 1 to 3),
or a partially hydrolyzed condensate thereof; reaction mixtures of a vinyl group-containing siloxane oligomer (including those with chain or cyclic structures) and an epoxy group-containing trialkoxysilane; methyl polysilicates; ethyl polysilicates; and epoxy group-containing ethyl polysilicates. The adhesion imparting agent is preferably in the form of a low viscosity liquid, and the viscosity thereof is not limited, but is preferably within the range of 1 to 500 mPa·s at 25°C. Furthermore, while not limited thereto, the amount of the adhesion imparting agent is preferably within the range of 0.01 to 10 parts by mass with respect to a total of 100 parts by mass of the present composition.

In the present invention, a reaction mixture of an organoalkoxysilane containing an amino group and an organoalkoxysilane containing an epoxy group is an example of a particularly preferable adhesion imparting agent. Such a component improves the initial adhesion of the curable silicone composition to various base materials with which the composition is in contact during a curing process, particularly low-temperature adhesion even to an unwashed adherend. Such a reaction mixture is disclosed in Japanese Examined Patent Publication 52-8854 and Japanese Unexamined Patent Application 10-195085.

Examples of alkoxysilanes having an amino group-containing organic group forming such a component include aminomethyltriethoxysilanes, 3-aminopropyltrimethoxysilanes, 3-aminopropyltriethoxysilanes, 3-aminopropylmethyldimethoxysilanes, N-(2-aminoethyl)aminomethyltributoxysilanes, N-(2-aminoethyl)-3-aminopropyltrimethoxysilanes, N-(2-aminoethyl)-3-aminopropylmethyldimethoxysilanes, and 3-anilinopropyltriethoxysilanes.

Furthermore, examples of epoxy group-containing organoalkoxysilanes include 3-glycidoxyprolyltrimethoxysilanes, 3-glycidoxypropylmethyldimethoxysilanes, 2-(3,4-epoxy cyclohexyl)ethyltrimethoxysilanes, and 2-(3,4-epoxy cyclohexyl)ethylmethyldimethoxysilanes.

The ratio of the alkoxysilane having an amino group-containing organic group to the alkoxysilane having an epoxy group-containing organic group is, in terms of molar ratio, preferably within the range of (1:1.5) to (1:5), and particularly preferably within the range of (1:2) to (1:4). This component can be easily synthesized by mixing an alkoxysilane having an amino group-containing organic group and alkoxysilane having an epoxy group-containing organic group as described above to cause a reaction at room temperature or by heating.

The curable hot-melt silicone composition of the present invention particularly preferably contains a carbasilatrane derivative expressed by the general formula: 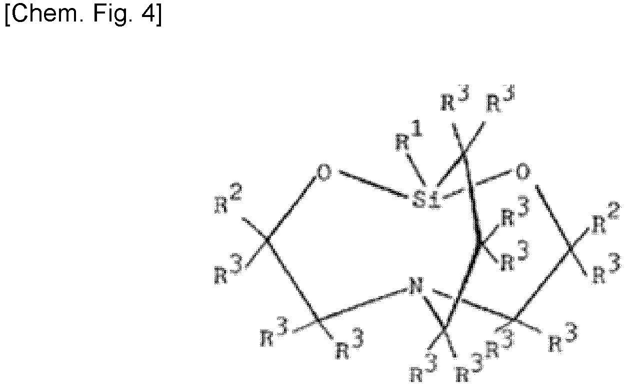
{where R¹ represents an alkyl group, an alkenyl group, or an alkoxy group, and R² represents the same or different group selected from the group consisting of groups expressed by the general formula: 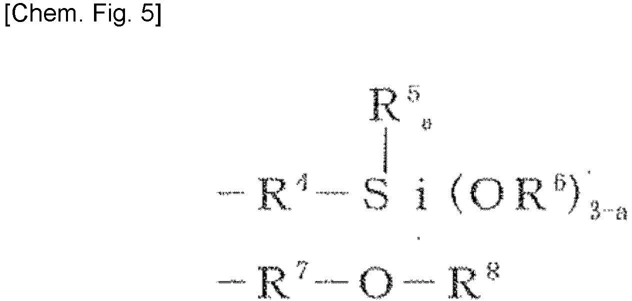
(where R⁴ represents an alkylene group or alkyleneoxyalkylene group, R⁵ represents a monovalent hydrocarbon group, R⁶ represents an alkyl group, R⁷ represents an alkylene group, R⁸ represents an alkyl group, alkenyl group, or acyl group, and "a" represents 0, 1, or 2.), and
R³ represents the same or different hydrogen atom or alkyl group.},
the carbasilatrane derivative being obtained by reacting an alkoxysilane having an amino group-containing organic group with an epoxy group-containing organic group and then cyclizing by an alcohol exchange reaction, by a method described in Japanese Unexamined Patent Application H10-195085. Examples of such carbasilatrane derivatives include carbasilatrane derivatives having a silicon atom-bonded alkoxy group or a silicon atom-bonded alkenyl group in one molecule expressed by the following structure: 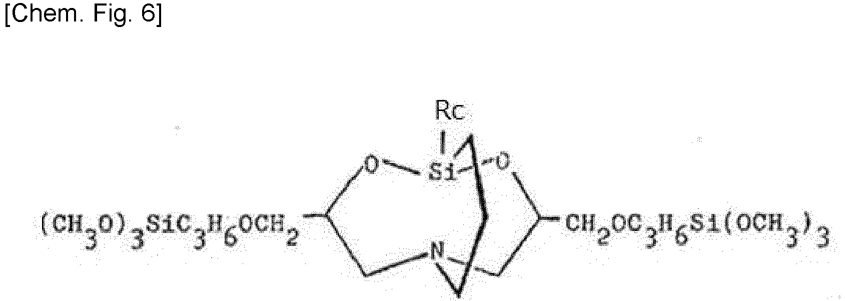
(where Rc represents a group selected from methoxy groups, ethoxy groups, vinyl groups, allyl groups, and hexenyl groups.)

Furthermore, in the present invention, a silatrane derivative expressed by the following structural formula may be used as the adhesion imparting agent. 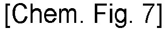 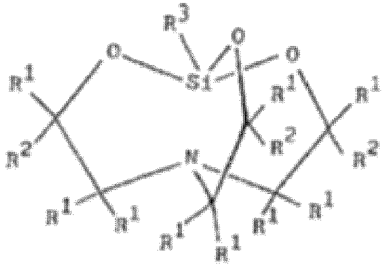 In the formula, R¹ represents the same or different hydrogen atom or alkyl group, with R¹ particularly preferably being a hydrogen atom or a methyl group. Furthermore, in the formula above, R² represents the same or different group selected from the group consisting of a hydrogen atom, an alkyl group, and an alkoxysilyl group-containing organic group expressed by general formula: -R⁴-Si(OR⁵)ₓR⁶₍₃₋ₓ₎, provided that at least one R² represents an alkoxysilyl group-containing organic group. Examples of alkyl groups R² include methyl groups and the like. Furthermore, in the alkoxysilyl group-containing organic group of R², R⁴ in the formula represents a divalent organic group. Examples thereof include alkylene groups and alkyleneoxyalkylene groups, with ethylene groups, propylene groups, butylene groups, methylene oxypropylene groups, and methylene oxypentylene groups being preferable. Furthermore, R⁵ in the formula represents an alkyl group having 1 to 10 carbon atoms, and preferably a methyl group or an ethyl group. Furthermore, R⁶ in the formula represents a substituted or unsubstituted monovalent hydrocarbon group, and preferably a methyl group. Furthermore, in the formula, x represents 1, 2, or 3, and preferably 3.

Examples of such alkoxysilyl group-containing organic groups of R² include the following groups:

-(CH₂)₂Si(OCH₃)₂(CH₂)₂Si(OCH₃)₂CH₃

-(CH₂)₃Si(OC₂H₅)₂(CH₂)₃Si(OC₂H₅)(CH₃)₂

-CH₂O(CH₂)₃Si(OCH₃)₃

-CH₂O(CH₂)₃Si(OC₂H₅)₃

-CH₂O(CH₂)₃Si(OCH₃)₂CH₃

-CH₂O(CH₂)₃Si(OC₂H₅)₂CH₃

-CH₂OCH₂Si(OCH₃)₂CH₂OCH₂Si(OCH₃)(CH₃)₂

R³ in the formula above represents at least one group selected from the group consisting of substituted or unsubstituted monovalent hydrocarbon groups, alkoxy groups having 1 to 10 carbon atoms, glycidoxyalkyl groups, oxiranylalkyl groups, and acyloxyalkyl groups. Examples of monovalent hydrocarbon groups of R³ include alkyl groups such as methyl groups and the like. Examples of alkoxy groups of R³ include methoxy groups, ethoxy groups, propoxy group, and the like. Examples of glycidoxypropyl groups of R³ include 3-glycidoxypropyl groups and the like. Examples of oxiranylalkyl groups of R³ include 4-oxiranylbutyl groups, 8-oxiraniloctyl groups, and the like. Examples of acyloxyalkyl groups of R³ include acetoxypropyl groups, 3-methacryloxypropyl groups, and the like. In particular, R³ preferably represents an alkyl group, an alkenyl group, or an alkoxy group, and more preferably an alkyl group or an alkenyl group, and particularly preferred examples thereof include groups selected from methyl groups, vinyl groups, allyl groups, and hexenyl groups.

The amount of component (F) used is not particularly limited, but from the perspective of improving adhesion to difficult-to-adhere base materials, the amount is preferably in the range of 0.1 to 1.0 mass% of the total composition, with 0.2 to 1.0 mass% being more preferred. Furthermore, the blending amount of component (G) may be in the range of 5 to 50 parts by mass, or may range from 5 to 40 parts by mass, with respect to a total of 100 parts by mass of component (A) and component (B).

Furthermore, the present composition may contain, as other optional components: iron oxide (red iron oxide), cerium oxide, cerium dimethylsilanolate, fatty acid cerium salts, cerium hydroxide, zirconium compounds, and other heat-resistant agents, dyes, non-white pigments, flame retardancy-imparting agents, aluminum hydroxide, magnesium hydroxide, zinc borate, zinc molybdate, phosphazene, and other heat reducers, hydrotalcite, bismuth oxides, yttrium oxides, and other ion scavengers and pH adjusters, aluminum hydroxide, magnesium hydroxide, zinc borate, zinc molybdate, phosphazene, and other flame retardants, hindered phenol compounds, hindered amine compounds, thioether compounds, and other antioxidants, pure iron, silicon steel, iron-cobalt alloy, iron-nickel alloy, iron-chromium alloy, iron-aluminum alloy, carbonyl iron, stainless steel, composite materials containing one or more thereof, and other soft magnetic particles, inorganic flame retardants (such as aluminum hydroxide and other hydrated metal compounds), halogenated flame retardants, phosphorus-based flame retardants, organometallic salt-based flame retardants, silicone oil, silicone rubber, polyisoprene, 1,2-polybutadiene, 1,4-polybutadiene, and other polybutadienes, styrene-butadiene rubber, acrylonitrile-butadiene rubber, butadiene acrylonitrile rubber blocked with a carboxyl group at an end, polychloroprene, poly(oxypropylene), poly(oxytetramethylene) glycol, polyolefin glycol, poly-ε-caprolactone, and other thermoplastic elastomers, polysulfide rubber, fluoroelastomer, and other stress reducing agents, barium titanate (BaTiOs), strontium titanate (SrTiOs), lead zirconate titanate (Pb(Zr, Ti)O₃, PZT), alumina (Al2O₃, aluminum oxide), zirconia (ZrO₂, zirconium dioxide), magnesia (MgO, magnesium oxide), silica (SiO2, silicon dioxide), titania (TiO2, titanium dioxide), aluminum nitride (AlN), silicon nitride (Si3N₄), silicon carbide (SiC), Barium calcium titanate zirconate (BCTZ), polyvinylidene fluoride, and other dielectric ceramics, copper chloride, cuprous iodide, copper acetate, cerium stearate, and other metal salt stabilizers, hindered amine-based organic compounds, hindered phenol-based organic compounds, sulfur-containing compound-based organic compounds, acrylate-based organic compounds, and phosphorus-based organic compounds, and other antioxidants and heat stabilizers; benzophenones, salicylates, benzotriazoles, and other UV absorbers, weathering agents, light stabilizers, and the like, so long as the object of the present invention is not impaired.

### [Granular Composition and Tableted Molded Body Thereof]

As described above, the curable silicone composition of the present invention is compositionally homogenized, and one characteristic thereof is that the composition is in the form of granules having a certain average particle size. Furthermore, the granular composition can be used in the form of pellet molded products or tablet molded products by tablet molding by a known method. Unlike the tablet molding of the granular compositions (mixtures) of Patent Document 1 and the like, the granular curable silicone composition according to the present invention is compositionally homogeneous. Therefore, the use of the same granular composition has the advantage of not only superior production efficiency of the tableted molded product, but also superior hot-melt properties, melt viscosity, and physical properties of the cured product of the resulting tableted molded body.

Herein, "pellet" and "tablet" are common names for granular tableted molded products containing a resin composition. The shape of the pellet/tablet is not limited, but is usually spherical, oval or cylindrical. Furthermore, the size of the pellet is not limited, but the pellet may, for example, have an average particle size or equivalent circular diameter of 500 µm or more or have an average particle size or equivalent circular diameter of 1 mm or more.

### [Method for Manufacturing Granular Curable Silicone Composition]

The present composition is in the form of compositionally homogenized granules in which the entire composition, including at least the components (A) to (C) above, is compositionally homogenized beyond the degree of mere mechanical force mixing. Such granular compositions are preferably obtained by melt kneading the entire composition with heating. More specifically, component (A) to component (C) are preferably melt kneaded, as well as any other optional components, in the temperature range of 50 to 150°C in a uniaxial or biaxial continuous mixer, dual rollers, roth mixer, kneader mixer, or the like, and then molded into granule form for use. Specific production methods are exemplified below.

The method for manufacturing the granular curable silicone composition of the present invention is not particularly limited so long as the method includes a step for melt kneading a curable silicone composition containing component (A) to component (C) above and any other optional components, wherein the amount of component (C) is in the range of 400 to 3000 parts by mass relative to a total of 100 parts by mass of component (A) and component (B), within a temperature range of 50 to 150°C, and then the mixture is molded into granular form in which the average particle size is in the range of 0.1 to 10.0 mm, and so long as the composition is formed into granules through melt kneading. For example, the method includes the following steps 1 to 3:
Step 1: Kneading the components of the curable silicone composition while heating and melting in the temperature range of 50 to 150°C
Step 2: Cooling the heated and melted mixture obtained in step 1 while discharging
Step 3: Cutting or pulverizing the mixture obtained in step 2 and then molding into a granular curable silicone composition

### [Step 1]

Step 1 above is a step for kneading the components of the curable silicone composition of the present invention while heating and melting in the temperature range of 50 to 150°C. Moreover, by heating and kneading the mixture having hot-melt properties at a temperature greater than or equal to the softening point thereof, and preferably in the temperature range of 50°C to 120°C, the entire composition is melted or softened and components (A) to (C) and optional components can be homogenously dispersed throughout.

The mixing device in step 1 is not limited, and can be: a kneader, a Banbury mixer, a Henschel mixer, a planetary mixer, a two-roller mill, a three-roller mill, a Ross mixer, a Labo Plastomill, or the like, or other batch type mixer, provided with heating and cooling functions; and a single-screw extruder, a twin-screw extruder, or other continuous type heating and kneading device, provided with heating and cooling functions. The mixing device is not particularly limited, but is selected in accordance with the efficiency of the processing time and the ability to control shear heat generation. In terms of the processing time, it may be a continuous heating and kneading device such as a single-screw extruder, a twin-screw extruder, or the like, or may be a batch mixer such as a Labo Plastomill. However, from the perspective of production efficiency of the granular curable silicone composition, a continuous heating and kneading device as a single-screw extruder, twin-screw extruder, and the like are preferably used.

The mixture is made into a granular form in step 3 via step 2. However, if the temperature is less than the lower limit above, softening is insufficient, which may make it difficult to obtain a melted or softened mixture in which each component is homogeneously dispersed throughout, even by a mechanical force. Moreover, such a mixture may not have excellent homogeneity of components, and when the resulting granular curable silicone composition is used in the molding step, a homogeneous cured product may not be obtained. On the other hand, if the temperature exceeds the aforementioned upper limit, the curing agent reacts during mixing, potentially causing the entire amount thereof to undergo significant thickening or curing, thereby losing hot-melt properties and forming a cured product, which is not preferable. Therefore, when a component for a hydrosilylation reaction is used as component (B), a microparticulate hydrosilylation reaction catalyst (for example, the component (B2) above) dispersed or encapsulated in a thermoplastic resin with a softening point at or above the kneading temperature is preferably used as a catalyst component thereof.

As for the method for feeding the components of the present invention into the aforementioned kneading device, each component may be fed separately to the kneading device at a constant rate, or all components may be powder-mixed by a mechanical force or the like into a granular curable silicone composition before being fed into the kneading device.

### [Step 2]

Step 2 is a step for discharging the mixture melted and kneaded by step 1 from the kneading machine. The mixture can be discharged in any shape, but the mixture is cut and pulverized in step 3 into a granular form. Therefore, a shape that is easy to cut and pulverize is preferably used. Examples include rod shapes (strand shape) with a diameter of approximately 0.5 to 5.0 mm or sheet shapes with a thickness of approximately 0.5 to 5.0 mm. The mixture is preferably a non-pressure-sensitive adhesive solid for granulation in step 3, and thus the temperature of the discharged mixture must be lowered to near room temperature by natural or rapid cooling. Examples of rapid cooling methods include methods using a cooler, water cooling, and the like.

### [Step 3]

Step 3 is a step for cutting or pulverizing and granulating the mixture discharged in step 2. If the mixture is hard enough to be pulverized only by shear stress at room temperature, the mixture can be pulverized and granulated by passing through two rollers or the like. Herein, the size and shape of the granules obtained by the present step 3 can be adjusted to a certain degree by controlling the dimensions of the mixture discharged in step 2 and the gap between the rollers. In the present invention, the average particle size of the granular molded product must be in the range of 0.1 to 10.0 mm. Furthermore, if the mixture cannot be pulverized by rolling or the like, the mixture can be discharged as a rod-shaped mixture in step 2 and cut to a prescribed size by a rotary cutter or the like while cooling to obtain granules.

The granular curable silicone composition obtained by the manufacturing method of the present invention has excellent flowability during hot-melting and is highly compositionally homogenized, making the composition less prone to non-homogeneity and physical migration of the composition during molding such as compression molding, press molding, lamination, and the like. Thus, there is an advantage where it is easy to homogenously form the entire composition, which is applicable even in a molding step in which shear pressure is not generated. Note that the advantages above are not lost even if the granular composition is secondary molded, and thus the granular curable silicone composition may be used as tablets or pellets for transfer molding by compressing or tableting with a tableting machine or the like.

### [Cured Product]

The aforementioned granular curable silicone composition and a tableted molded product thereof have hot-melt properties and have excellent flowability when melted (hot-melted), excellent handling workability and curability, and form a cured product suitable for a semiconductor member or the like when cured. Depending on the type of the curing agent serving as component (B), the curing method can be selected from known curing methods such as heat curing, light curing using a high energy beam such as ultraviolet light or the like, moisture curing, and the like. When component (B) is selected from a thermal radical polymerization initiator such as organic peroxide or the like and a hydrosilylation reaction catalyst/hydrosilylation reaction cross-linking agent, curing is preferably performed by heat curing in the range of 80°C to 200°C. Note that in the present invention, physical properties such as the linear expansion coefficient, bending strength, and hardness of the cured product can be easily designed to the following suitable ranges based on the type of component (A) and the quantitative range of component (C).

### [Linear Expansion Coefficient of Cured Product]

The cured product obtained by curing the composition has an average linear expansion coefficient of 30 ppm/°C or lower, and preferably 20 ppm/°C or lower, within a range of 25°C to 200°C. Within this range, the difference in average linear expansion coefficient between the cured product and the substrate used is low. Therefore, the residual stress in the obtained integrated molded product can be reduced, improving the reliability of a device.

### [Bending Strength of Cured Product]

Furthermore, it is suitable as a sealing material for a semiconductor which is required to have high hardness and high strength, and therefore, the bending strength of the cured product measured by the method specified in JIS K 6911-1995 "General Testing Method for Thermosetting Plastics" is preferably 15 MPa or more, or 20 MPa or more.

### [Hardness of Cured Product]

It is suitable as a protective member for a semiconductor or the like, and therefore, the cured product obtained by curing the present composition preferably has a type-D durometer hardness of 20 or more at 25°C. Note that this type-D durometer hardness is determined by the type-D durometer in accordance with the JIS K 6253-1997 "Hardness Testing Methods for Vulcanized Rubber and Thermoplastic Rubber."

### [Method for Molding Cured Product]

The present composition (including the granular composition and pellet molded product or tablet molded product, which are tableted molded products thereof; the same applies hereinafter) can be cured by a method including at least the following steps (I) to (III):
(I) Step of heating the present composition to a temperature of 100°C or higher to melt the composition;
(II) Step of injecting the curable silicone composition obtained in the aforementioned step (I) into a metal die or step of distributing the curable silicone composition obtained in the aforementioned step (I) to a metal die by clamping; and
(III) Step of curing the curable silicone composition injected in the aforementioned step (II).

The present composition exhibits relatively low melt viscosity at a temperature of 100°C or higher, and thus has excellent hot-melt properties, flowability, and gap-filling properties under pressure, making it suitable for use in molding methods that include a coating step (so-called mold underfill method) in which a semiconductor element is overmolded and underfilled at a time.

Furthermore, based on the properties described above, the present composition can be suitably used in a molding method including a coating step (so-called wafer molding) in which the surface of a semiconductor substrate (including wafer substrates) on which a single or a plurality of semiconductor elements are mounted is covered and overmolded such that gaps between the semiconductor elements are filled with the cured product.

A transfer molding machine, compression molding machine, injection molding machine, press molding machine, auxiliary ram molding machine, sliding molder, double ram molding machine, molding machine for low-pressure sealing, or the like can be used in the molding step described above.

In step (III) above, the curable silicone composition injected (applied) in step (II) is cured. The curing method varies depending on the type of component (B), but when component (B) is selected from organic peroxides and other thermal radical polymerization initiators and hydrosilylation reaction catalysts/hydrosilylation reaction cross-linking agents, curing by heat curing in the range of 80°C to 200°C is preferable. In particular, when an organic peroxide is used as Component (B), the heating temperature is preferably 150°C or higher or 170°C or higher.

### [Use of Composition]

The granular curable silicone composition according to the present invention (including tablet molded products and pellet molded products, which are tableted molded products thereof) has favorable hot-melt properties, flowability when melted (hot-melted), handling workability, and curability. Therefore, the granular curable silicone composition is suitable as a sealing agent or underfill agent for a semiconductor; a sealing agent or underfill agent for a power semiconductor of SiC, GaN, and the like; a sealing agent or light reflective material for an optical semiconductor such as light emitting diodes, photodiodes, phototransistors, laser diodes, and the like; and an adhesive or protective agent for electrical and electronic applications. Furthermore, the present composition has hot-melt properties, making it suitable as a material for transfer molding, compression molding, press molding, or injection molding. In particular, it is suitable for use as a sealing agent for semiconductors that use the mold underfill method or the wafer molding method during molding.

The present composition is suitable as a sealing agent or the like for a semiconductor as described above, and can be partially or entirely used in place of a conventionally known sealing agent, in a step of sealing a semiconductor or the like by an overmolding method, an underfilling method, a mold underfilling method simultaneously performing these, a wafer molding method, or other molding method using a conventionally known sealing agent (including epoxy sealing agents and other non-silicone-based hot-melt sealing agents), to manufacture a semiconductor package, a power semiconductor module, MEMS, a microsensor (fingerprint sensor), or other small integrated device, a coil containing magnetic particles, or other magnetic member, a flexible substrate (stretchable wiring board) for a wearable device or the like, an optical waveguide connected to an electrical wiring board or connector, or other semiconductor/optical member. For example, the curable silicone composition according to the present invention can be partially or entirely used in place of the sealing agents (particularly including silicone elastomer sealing agents, pastes containing a functional filler, and hot-melt sealing agents) described in Japanese Unexamined Patent Application 2021-097123, Japanese Unexamined Patent Application 2021-024945, Japanese Unexamined Patent Application 2020-132771, Japanese Unexamined Patent Application 2020-132750, Japanese Unexamined Patent Application 2020-125399, Japanese Unexamined Patent Application 2020-123670, Japanese Unexamined Patent Application 2020-084094, Japanese Unexamined Patent Application 2020-088055, Japanese Unexamined Patent Application 2019-006905, Japanese Unexamined Patent Application 2018-188494, Japanese Unexamined Patent Application 2017-179185, Japanese Unexamined Patent Application 2020-023643, Japanese Unexamined Patent Application 2020-063459, Japanese Unexamined Patent Application 2020-090634, Japanese Unexamined Patent Application 2020-088055, Japanese Unexamined Patent Application 2020-107767, Japanese Unexamined Patent Application 2021-080411, Japanese Unexamined Patent Application 2021-036013, Japanese Unexamined Patent Application 2020-152844, Japanese Unexamined Patent Application 2020-158684, Japanese Unexamined Patent Application 2021-019031, Japanese Unexamined Patent Application 2021-059741, Japanese Unexamined Patent Application 2020-057775, Japanese Unexamined Patent Application 2021-015985, Japanese Unexamined Patent Application 2015-114390, Japanese Unexamined Patent Application 2016-177106, and the like. Note that if necessary, technical elements applicable to these sealing agent compositions may be applied to the present invention, and the composition according to the present invention may and is preferably adjusted with respect to the composition thereof, cured product physical properties, melting properties, and the like.

### [Use of Cured Product]

Although the application of the cured product according to the present invention is not particularly limited, the granular curable silicone composition according to the present invention (including tablet molded products and pellet molded products, which are tableted molded products thereof) has hot-melt properties and excellent moldability, and the resulting cured product has excellent adhesive properties, high modulus of elasticity, and low coefficient of linear expansion. Therefore, the cured product according to the present invention can be suitably used as a member for a semiconductor device, and can be used as a sealing material for a semiconductor element, IC chip, or the like, or as a light reflective material for an optical semiconductor device.

A semiconductor device provided with a member containing the cured product of the present invention is not particularly limited, but is particularly preferably a semiconductor device mounted on a power semiconductor device, an optical semiconductor device, and a flexible semiconductor device that can expand, contract, or deform.

### EXAMPLES

The hot-melt curable silicone composition of the present invention and manufacturing method thereof are described in detail using examples and comparative examples. Note that in the formulas, Me, Ph, and Vi represent a methyl group, a phenyl group, and a vinyl group, respectively. Furthermore, the softening points and melt viscosities of the curable silicone compositions of each example and comparative example were measured by methods below. Furthermore, the curable silicone compositions were heated at 180°C for two hours to prepare cured products, and adhesion to various base materials were measured by a method below. The results are shown in Table 1.

### [Softening Point of Curable Silicone Composition]

The curable silicone composition was molded into cylindrical pellets of ϕ14 mm x 22 mm. The pellet was placed on a hot plate set at 25°C to 100°C and continuously pressed from above for 10 seconds by a load of 100 grams, and after the load was removed, the amount of deformation of the pellet was measured. The temperature at which the deformation amount in the height direction was 1 mm or more was defined as the softening point.

### [Melt Viscosity]

The melt viscosity of the curable silicone composition at 180°C was measured using a Koka type flow tester CFT-500EX (manufactured by Shimadzu Corporation) using a 1.0 mm diameter nozzle under a pressure of 100 kgf.

### [Bending Strength of Cured Product]

The curable silicone composition was heated at 180°C for two hours to prepare a cured product. The bending strength of the cured product was determined by a method specified in JIS K 6911-1995 "General Testing Method for Thermosetting Plastics".

### [Linear Expansion Coefficient Curve of Cured Product]

The curable silicone composition of Example 1 was cured by the method described above to prepare a cured product. The linear expansion coefficient of the cured product was measured by TM9200 manufactured by SHINKU-RIKO Inc. in the temperature range of 20°C to 200°C.

Main agents containing component (A) of the present invention were prepared by methods indicated in Reference Examples 1 to 5. The presence or absence of hot-melt properties of component (A) used was evaluated based on the softening point/melt viscosity.

### [Reference Example 1]

A toluene solution of a resinous organopolysiloxane (1) was prepared in a 1 L flask by dissolving in 450 g of toluene 550 g of a resinous organopolysiloxane, which is a white solid at 25°C and expressed by the average unit formula:

(PhSiO_{3/2})_{0.80}(Me₂ViSiO_{1/2})_{0.20}

Furthermore, the molecular weight (Mw) of the resinous organopolysiloxane (1) obtained by GPC measurement under the toluene solvent was 1600, the softening point was 100°C, and the viscosity measured by a rotational viscometer at 150°C was 30 Pa s.

### [Reference Example 2: Hot-melt Organopolysiloxane Resin Microparticles (P1)]

True spherical hot-melt organopolysiloxane resin microparticles (P1) were prepared by microparticulating the toluene solution of the resinous organopolysiloxane (1) prepared in Reference Example 1 while removing toluene by spray drying at 40°C. Observation of the microparticles using an optical microscope revealed that the particle size was 5 to 10 µm and the average particle size was 7.9 µm.

For use in comparative experiments, a resinous organosiloxane block copolymer C1 with an intramolecular block structure of resinous and chain siloxanes was prepared by the method indicated in Reference Example 3, and the organopolysiloxane resin microparticles (C1) were prepared by the method indicated in Reference Example 4. The presence or absence of hot-melt properties was evaluated based on the presence or absence of a softening point/melt viscosity.

### [Reference Example 3]

318.6 g of a toluene solution (56.5 wt% in solid fraction concentration, Si: 1.318 mols) of phenyl resin (217 Flake manufactured by Dow Corning Corp.) expressed by
Average unit formula: (PhSiO_{3/2})ₙ (where "n" represents a positive number in which the Mw is 1500)
was introduced into a 500 mL four-neck round bottom flask under a nitrogen atmosphere. The flask was provided with a thermometer, a Teflon (registered trademark) stirring blade, and a Dean-Stark device (pre-filled with toluene) connected to a water-cooled condenser. The reaction mixture of the aforementioned components was heated at reflux for 30 minutes to remove 0.54 g of water. The reaction solution was cooled to 108°C, followed immediately by the addition of 50/50 MTA/ETA (methyltriacetoxysilane/ethyltriacetoxysilane, 4.24 g, Si: 0.0187 mols) to methylphenylpolysiloxane blocked with silanol groups at both molecular chain ends (220 g, Si: 1.614 mols, DP = 181), and then 224.24 g of MTA/ETA-capped methylphenylpolysiloxane blocked with silanol groups at both molecular chain ends, synthesized by stirring in a glove box at room temperature for one hour, was added. The reaction mixture was heated under reflux in a nitrogen atmosphere for two hours to remove 2.01 g of water. The reaction solution was cooled again to 108°C, and vinylmethyl diacetoxysilane (11.91 g, Si: 0.0633 mol) was added, followed by refluxing for one hour to remove 1.05 g of water. Next, the reaction mixture was cooled to 90°C and deionized water (47.8 g) was added, followed by refluxing to remove the water by azeotropic distillation. The reaction solution was cooled again to 108°C and 50/50 MTA/ETA (methyltriacetoxysilane/ethyltriacetoxysilane) (21.57 g, Si: 0.0949 mols) was added. Next, after refluxing for one hour, the reaction mixture was allowed to cool to 90°C and deionized water (47.8 g) was added, followed by refluxing to remove water by azeotropic distillation (this procedure of adding and removing water was repeated twice). The same water treatment was repeated three times, and finally, the volatile fraction (103.6 g) was removed by distillation at 118°C, increasing the solid fraction of the reaction solution to approximately 70%.

The resinous organosiloxane block copolymer C1 having intramolecular resinous and chain siloxane block structures was synthesized by the steps above. The copolymer C1 was transparent and colorless and contained 2 mol% vinyl groups. The molecular weight (Mw) thereof obtained by GPC measurement under a toluene solvent was 89,571, the softening point was 100°C, and the viscosity measured by a rotational viscometer at 150°C was 10,000 Pa s.

### [Reference Example 4]

The aforementioned organosiloxane block copolymer C1 was finely powdered while removing toluene by spray drying to obtain true spherical resinous organosiloxane block copolymer microparticles (C1). The resulting powder was observed under an optical microscope to be a true spherical powder of 5 to 10 µm.

### [Reference Example 5]

A liquid silicone mixture (L1) was obtained by mixing the following in a 1 L flask: 100 g of a resinous organopolysiloxane that is a white solid at 25°C and expressed by the average unit formula:

(PhSiO_{3/2})_{0.80}(Me₂ViSiO_{1/2})_{0.20}

3.0 g of a diphenylsiloxane blocked at both molecular chain ends with dimethylhydrogensiloxy groups, expressed by

Formula: HMe₂SiO(Ph₂SiO)SiMe₂H

and having a viscosity of 5 mPa·s (amount of silicon atom-bonded hydrogen atoms = 0.6 mass%)
28.0 g of branched organopolysiloxane expressed by
Average unit formula:

   (PhSiO_{3/2})_{0.4}(HMe₂SiO_{1/2})_{0.6}
having two or more silicon atom-bonded hydrogen atoms in one molecule, and having a viscosity of 25 mPa·s (amount of silicon atom-bonded hydrogen atoms = 0.65 mass%)

### [Examples 1 to 3, Manufacturing Example 1 (Comparative Example 1), Manufacturing Examples 2 to 3, Comparative Example 2]

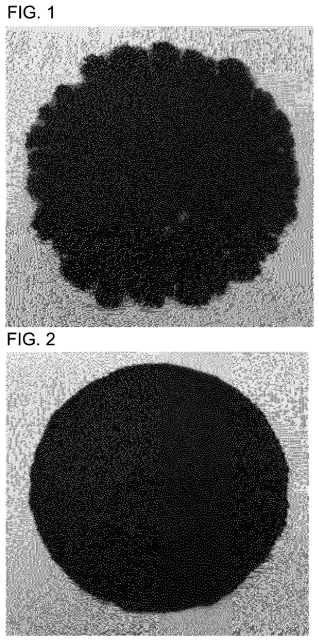

The following experiments were performed using the hot-melt organopolysiloxane resin microparticles (P1) obtained in Reference Example 2 and the liquid silicone mixture obtained in Reference Example 5 for Manufacturing Example 1 (Comparative Example 1), Manufacturing Examples 2 and 3, and Examples 1, 2 and 3. Furthermore, for comparison, the experiment described in Comparative Example 2 was conducted using the organosiloxane block copolymer microparticles (C1) obtained in Reference Example 4. Note that for the compositions for Manufacturing Example 1 (Comparative Example 1) and Example 1, a pressure test was conducted at a pressure of 5 MPa using a heat pressing machine set at a temperature of 180°C. The crushed compositions are depicted in FIGS. 1 and 2.

### [Manufacturing Example 1 (Comparative Example 1)]

1394.0 g of molten silica (S6105P manufactured by Nippon Steel Materials Co., Ltd., Micron Co., Ltd.) with an average particle size of 14.5 µm, 153 g of fused silica (SPH507M manufactured by Micron Co., Ltd., a subsidiary of Nippon Steel Materials Co., Ltd.) with an average particle size of 0.7 µm, 1.7 g of DENKA BLACK pressed product (manufactured by DENKA Company Limited), 1.7 g of calcium stearate (manufactured by KAWAMURA KASEI INDUSTRY CO., LTD.), and 5.7 g of a dimethylpolysiloxane with a viscosity of 23 MPa·s and expressed by the formula:

Me₂ViSiO(Me₂SiO)₂₉Si(OMe)₃

were introduced at once in a small pulverizer, and stirred for one minute at 100°C. The fused silica was surface treated and then the temperature of the pulverizer was returned to 25°C. Next, the following components were additionally introduced into a small pulverizer and stirred at room temperature (25°C) for one minute to prepare a uniform granular black and white curable silicone composition:
57.2 g of the hot-melt organopolysiloxane resin microparticles (P1) obtained in Reference Example 2;
5.7 g of a branched organopolysiloxane expressed by

   Formula: (ViMe₂SiO_{1/2})_{0.75}(PhSiO_{3/2})_{0.25},
having a viscosity of 5 mPa s, and having a vinyl group on a molecular end (amount of vinyl groups = 23 mass%);
2.9 g of a diphenylsiloxane blocked with dimethylhydrogensiloxy groups at both molecular chain ends, expressed by

   Formula: HMe₂SiO(Ph₂SiO)SiMe₂H
and having a viscosity of 5 mPa·s (amount of silicon atom-bonded hydrogen atoms = 0.6 mass%);
22.3 g of a branched organopolysiloxane expressed by Average unit formula:

   (PhSiO_{3/2})_{0.4}(HMe₂SiO_{1/2})_{0.6},
having two or more silicon atom-bonded hydrogen atoms in one molecule, and having a viscosity of 25 mPa·s (amount of silicon atom-bonded hydrogen atoms = 0.65 mass%);
{an amount such that the silicon atom-bonded hydrogen atoms in the diphenylsiloxane and branched phenylsiloxane is 1.0 mol relative to 1.0 mol of vinyl groups in the present composition}
methyltris-1,1-dimethyl-2-propynyloxysilane (boiling point = 245°C (1013.25 hPa) at an amount of 300 ppm in mass units relative to the present composition);
5.7 g of bis(trimethoxysilylpropoxymethyl)vinylsilatrane; and
0.06 parts by mass of a thermoplastic polycarbonate resin containing 4000 ppm of a 1,3-divinyl-1,1,3,3-tetramethyldisiloxane complex of Pt (0 valence) as the platinum amount (softening point = 150°C).

The resulting granular composition was observed under an optical microscope, and most had particle sizes of 10 to 100 µm. Furthermore, the melt viscosity of the composition was 17 Pa·s at 180°C. FIG. 1 depicts the resulting granular curable silicone composition when crushed in a press set at 180°C with a pressure of 5 MPa. Furthermore, the bending strength and coefficient of linear expansion of a cured product containing the resulting curable silicone composition were measured by the aforementioned methods, and were 52 MPa and 13 ppm/°C, respectively.

### [Example 1]

The curable silicone composition obtained in Manufacturing Example 1 was introduced into a kneader mixer set at 90°C and melt kneaded for five minutes to obtain an integrated composition that is solid at room temperature. An irregular granular curable silicone composition was prepared by pulverizing this solid fraction while cooling to 0°C. The resulting granular composition was observed under an optical microscope, where most were granules having a particle size of 1.0 to 5.0 mm. The average particle size thereof was 2.2 mm. Furthermore, the melt viscosity of the composition was 17 Pa·s at 180°C. FIG. 2 depicts the resulting granular curable silicone composition when crushed in a press set at 180°C with a pressure of 5 MPa. Furthermore, the bending strength and coefficient of linear expansion of a cured product containing the resulting curable silicone composition were measured by the aforementioned methods, and were 54 MPa and 12 ppm/°C, respectively.

### [Comparative Example 2-1]

360 g of molten silica (S6105P manufactured by Nippon Steel Materials Co., Ltd., Micron Co., Ltd.) with an average particle size of 14.5 µm, 40 g of fused silica (SPH507M manufactured by Micron Co., Ltd., a subsidiary of Nippon Steel Materials Co., Ltd.) with an average particle size of 0.7 µm, 0.5 g of DENKA BLACK pressed product (manufactured by DENKA Company Limited), 0.5 g of calcium stearate (manufactured by KAWAMURA KASEI INDUSTRY CO., LTD.), and 1.5 g of a dimethylpolysiloxane with a viscosity of 23 MPa·s and expressed by the formula:

Me₂ViSiO(Me₂SiO)₂₉Si(OMe)₃

were introduced at once in a small pulverizer, and stirred for one minute at 100°C. The fused silica was surface treated and then the temperature of the pulverizer was returned to 25°C. Next, the following components were additionally introduced into a small pulverizer and stirred at room temperature (25°C) for one minute to prepare a uniform granular black curable silicone composition:
90.9 g of the organosiloxane block copolymer (C1) obtained in Reference Example 4;
9.1 g of a branched organopolysiloxane expressed by
   Average unit formula:

   (PhSiO_{3/2})_{0.4}(HMe₂SiO_{1/2})_{0.6},
having two or more silicon atom-bonded hydrogen atoms in one molecule, and having a viscosity of 25 mPa·s (amount of silicon atom-bonded hydrogen atoms = 0.65 mass%);
{an amount such that the silicon atom-bonded hydrogen atoms in the diphenylsiloxane and branched phenylsiloxane is 1.0 mol relative to 1.0 mol of vinyl groups in the present composition}
methyltris-1,1-dimethyl-2-propynyloxysilane (boiling point = 245°C (1013.25 hPa) at an amount of 300 ppm in mass units relative to the present composition);
1.5 g of bis(trimethoxysilylpropoxymethyl)vinylsilatrane; and 0.025 parts by mass of a thermoplastic polycarbonate resin containing 4000 ppm of a 1,3-divinyl-1,1,3,3-tetramethyldisiloxane complex of Pt (0 valence) as the platinum amount (softening point = 150°C).

Furthermore, the melt viscosity of the composition was 3400 Pa·s at 180°C.

### [Comparative Example 2-2]

The curable silicone composition obtained in Comparative Example 2-1 was introduced into a kneader mixer set at 90°C and melt kneaded for five minutes to obtain an integrated composition that is solid at room temperature. An irregular granular curable silicone composition was prepared by pulverizing this solid fraction while cooling to 0°C. The resulting granular composition was observed under an optical microscope, where most were granules having a particle size of 1.0 to 5.0 mm. Furthermore, the melt viscosity of the composition was 3000 Pa·s at 180°C.

### [Manufacturing Example 2]

1394.0 g of molten silica (S6105P manufactured by Nippon Steel Materials Co., Ltd., Micron Co., Ltd.) with an average particle size of 14.5 µm, 153 g of fused silica (SPH507M manufactured by Micron Co., Ltd., a subsidiary of Nippon Steel Materials Co., Ltd.) with an average particle size of 0.7 µm, 1.7 g of DENKA BLACK pressed product (manufactured by DENKA Company Limited), 1.7 g of calcium stearate (manufactured by KAWAMURA KASEI INDUSTRY CO., LTD.), and 5.7 g of a dimethylpolysiloxane with a viscosity of 23 MPa·s and expressed by the formula:

Me₂ViSiO(Me₂SiO)₂₉Si(OMe)₃

were introduced at once in a small pulverizer, and stirred for one minute at 100°C. The fused silica was surface treated and then the temperature of the pulverizer was returned to 25°C. Next, the following components were additionally introduced into a small pulverizer and stirred at room temperature (25°C) for one minute to prepare a uniform granular black curable silicone composition:
88.1 g of the liquid silicone mixture (L1) obtained in Reference Example 5; methyltris-1,1-dimethyl-2-propynyloxysilane (boiling point = 245°C (1013.25 hPa) at an amount of 300 ppm in mass units relative to the present composition);
5.7 g of bis(trimethoxysilylpropoxymethyl)vinylsilatrane; and
0.06 parts by mass of a thermoplastic polycarbonate resin containing 4000 ppm of a 1,3-divinyl-1,1,3,3-tetramethyldisiloxane complex of Pt (0 valence) as the platinum amount (softening point = 150°C). The resulting granular composition was observed under an optical microscope, and most had particle sizes of 10 to 100 µm.

### [Manufacturing Example 3]

1394.0 g of molten silica (S6105P manufactured by Nippon Steel Materials Co., Ltd., Micron Co., Ltd.) with an average particle size of 14.5 µm, 153 g of fused silica (SPH507M manufactured by Micron Co., Ltd., a subsidiary of Nippon Steel Materials Co., Ltd.) with an average particle size of 0.7 µm, 1.7 g of DENKA BLACK pressed product (manufactured by DENKA Company Limited), 1.7 g of calcium stearate (manufactured by KAWAMURA KASEI INDUSTRY CO., LTD.), and 5.7 g of a dimethylpolysiloxane with a viscosity of 23 MPa·s and expressed by the formula:

Me₂ViSiO(Me₂SiO)₂₉Si(OMe)₃

were introduced at once in a small pulverizer, and stirred for one minute at 100°C. The fused silica was surface treated and then the temperature of the pulverizer was returned to 25°C. Next, the following components were additionally introduced into a small pulverizer and stirred at room temperature (25°C) for one minute to prepare a uniform granular black curable silicone composition:
88.1 g of the liquid silicone mixture (L1) obtained in Reference Example 5; methyltris-1,1-dimethyl-2-propynyloxysilane (boiling point = 245°C (1013.25 hPa) at an amount of 600 ppm in mass units relative to the present composition);
5.7 g of bis(trimethoxysilylpropoxymethyl)vinylsilatrane; and a 1,3-divinyl-1,1,3,3-tetramethyldisiloxane complex of Pt (0 valence) (at amount of 5 ppm as the platinum amount with respect to the present composition).

The resulting granular composition was observed under an optical microscope, and most had particle sizes of 10 to 100 µm.

### [Example 2]

The curable silicone composition obtained in Manufacturing Example 2 was introduced into a kneader mixer set at 90°C and melt kneaded for five minutes to obtain an integrated composition that is solid at room temperature. An irregular granular curable silicone composition was prepared by pulverizing this solid fraction while cooling to 0°C. The resulting granular composition was observed under an optical microscope, where most were granules having a particle size of 1.0 to 5.0 mm. The average particle size thereof was 1.9 mm. Furthermore, the melt viscosity of the composition was 25 Pa·s at 180°C. Furthermore, the bending strength and coefficient of linear expansion of a cured product containing the resulting curable silicone composition were measured by the aforementioned methods, and were 62 MPa and 12 ppm/°C, respectively.

### [Example 3]

The curable silicone composition obtained in Manufacturing Example 3 was introduced into a kneader mixer set at 90°C and melt kneaded for two minutes to obtain an integrated composition that is solid at room temperature. An irregular granular curable silicone composition was prepared by pulverizing this solid fraction while cooling to 0°C. The resulting granular composition was observed under an optical microscope, where most were granules having a particle size of 1.0 to 5.0 mm. The average particle size thereof was 1.4 mm. Furthermore, the melt viscosity of the composition was 170 Pa·s at 180°C. Furthermore, the bending strength and coefficient of linear expansion of a cured product containing the resulting curable silicone composition were measured by the aforementioned methods, and were 59 MPa and 12 ppm/°C, respectively.

**[Table 1]**

| | Comparative Example 1 | Example 1 | Comparative Example 2 |
|---|---|---|---|
| Main agent | Organopolysiloxane resin microparticles (P1) | Organopolysiloxane resin microparticles (P1) | Organosiloxane block copolymer microparticles (C1) |
| With or without melt kneading and granulating | Without melt kneading (granular mixture) | With melt kneading (granular molded product) | With melt kneading (granular molded product) |
| Melt viscosity at 180°C (Pa·s) | 17 | 17 | 3000 |
| Homogeneity during heat pressing | Nonhomogeneous (FIG. 1) | Homogenous (FIG. 2) | Homogenous |

| | Example 2 | Example 3 | |
|---|---|---|---|
| Main agent | Liquid silicone mixture (L1) | Liquid silicone mixture (L1) | |
| With or without melt kneading and granulating | With melt kneading (granular molded product) | With melt kneading (granular molded product) | |
| Melt viscosity at 180°C (Pa·s) | 25 | 170 | |
| Homogeneity during heat pressing | Homogenous | Homogenous | |

### [Summary]

In Examples 1 to 3 according to the present invention, granular curable silicone compositions that were compositionally homogenous and had an average particle size in the range of 1 to 5 mm were obtained by melt kneading. The composition had excellent hot-melt properties and low melt viscosity at 180°C. Moreover, evaluation by heat press showed that the crushed composition was homogenous and no separation of the silicone component and inorganic filler was observed. Therefore, it is expected that the granular compositions according to Examples 1 to 3 have particularly excellent gap-filling properties and can be suitably used for sealing a semiconductor or the like by compression molding or press molding.

Furthermore, the melt viscosity of the granular curable silicone compositions obtained by melt kneading was sufficiently low in Examples 1 and 2, which used a curing reaction catalyst that is active in the composition upon thermal energy stimulation at 80°C or higher without dissolving in the components of the present composition. However, the melt viscosity of the composition in Example 3, which did not use a curing reaction catalyst that is active in the composition due to thermal energy stimulation at 80°C or higher, was relatively high. This is thought to be due to some thickening caused by the reaction progressing during melt kneading.

On the other hand, the composition of Comparative Example 1 (a precursor to Example 1 and corresponding to the examples in Patent Document 1 and the like), which is a granular mixture that did not undergo melt kneading, had a low melt viscosity at 180°C, but was not homogenized, resulting in a non-homogenous state during heat pressing. Moreover, separation of the silicone component and inorganic filler was observed. Furthermore, in Comparative Example 2, in which the organosiloxane block copolymer microparticles (C1) having the intramolecular resinous and chain block structures were used, the melt viscosity at 180°C was too high when the same amount of inorganic filler is included, even if melt kneading was performed as in Example 1. Therefore, sufficient fluidity cannot be achieved. Thus, there is a concern that the product is not suitable for molding steps that require filling small gaps or allowing material to flow to a certain degree.

In Manufacturing Example 1 (Comparative Example 1) and Comparative Example 2-1, fine granular curable silicone compositions with a particle size of 100 µm or less were obtained, while in Examples 1 to 3 and Comparative Example 2-2, granular curable silicone compositions with a particle size of 100 µm or more were manufactured. In particular, in Examples 1 to 3, the compositions were made in the form of granules of 100 µm or more, which prevents dust from flying during use. Thus, handling in the sealing step and the like can be expected to be improved.

## Claims

1. A granular curable silicone composition, comprising:
(A) an organopolysiloxane resin containing at least 20 mol% or more of a siloxane unit as expressed by RSiO_{3/2} (where R represents a monovalent hydrocarbon group) with respect to all siloxane units;
(B) a curing agent; and
(C) a functional inorganic filler, wherein
the amount of component (C) is 400 to 3000 parts by mass relative to a total of 100 parts by mass of component (A) and component (B),
the composition is a solid at 25°C and has a melt viscosity of 200 Pa·s or less as measured by a flow tester at 180°C, and
the average particle size thereof is in the range of 0.1 to 10.0 mm.

2. The granular curable silicone composition according to claim 1, wherein the curable silicone composition is compositionally homogenized by melt kneading in the temperature range of 50 to 150°C, and then is molded into a granular form.

3. The granular curable silicone composition according to claim 1 or 2, wherein component (B) is a curing agent containing a curing reaction catalyst that is insoluble in another component of the present composition at room temperature and is active in the composition by thermal energy stimulation at 80°C or higher.

4. The granular curable silicone composition according to any one of claims 1 to 3, wherein component (B) contains one or more types of curing agents selected from:
(B1) organic peroxides with a half-life of 10 hours at a temperature of 80°C or higher; and
(B2) hydrosilylation reaction catalyst-containing thermoplastic resin microparticles containing a thermoplastic resin with a softening point or glass transition point of 80°C or higher.

5. The granular curable silicone composition according to any one of claims 1 to 4, wherein the weight average molecular weight (Mw) of component (A) is 20,000 or less.

6. The granular curable silicone composition according to any one of claims 1 to 5, wherein at least some or all of component (A) is
(A1) a hot-melt organopolysiloxane resin with a softening point of 30°C or higher, having a curing reactive functional group containing at least one carbon-carbon double bond in a molecule, and containing at least 20 mol% or more of a siloxane unit expressed by RSiO_{3/2} (where R represents a monovalent hydrocarbon group) with respect to all siloxane units.

7. The granular curable silicone composition according to any one of claims 1 to 6, wherein at least some or all of component (A) is
(A1-1) a hot-melt organopolysiloxane resin with a softening point of 30°C or higher, having a curing reactive functional group containing at least one carbon-carbon double bond in a molecule, containing at least 20 mol% or more of a siloxane unit expressed by RSiO_{3/2} (where R represents a monovalent hydrocarbon group) with respect to all siloxane units, and in which 10 mol% or more of silicon atom-bonded organic groups are aryl groups.

8. The granular curable silicone composition according to any one of claims 1 to 7, wherein component (C) is a reinforcing filler, white pigment, thermally conductive filler, electrically conductive filler, phosphor, or a mixture of at least two or more types thereof.

9. The granular curable silicone composition according to any one of claims 1 to 8, wherein curing provides a cured product with a bending strength of 15 MPa or more as measured using a method specified in JIS K6911-1995 "General Testing Method for Thermosetting Plastics".

10. A pellet molded product or tablet molded product obtained by tablet molding the granular curable silicone composition according to any one of claims 1 to 9.

11. A cured product obtained by curing the granular curable silicone composition according to any one of claims 1 to 9 or the pellet molded product or tablet molded product according to claim 10.

12. A member for a semiconductor device, comprising the cured product according to claim 11.

13. A semiconductor device comprising the cured product according to claim 11.

14. A method for manufacturing a granular curable silicone composition according to any one of claims 1 to 9, comprising the step of melt kneading a curable silicone composition containing:
(A) an organopolysiloxane resin containing at least 20 mol% or more of siloxane units as expressed by RSiO_{3/2} (where R represents a monovalent hydrocarbon group) with respect to all siloxane units;
(B) a curing agent; and
(C) a functional inorganic filler,
the composition having a component (C) amount in the range of 400 to 3000 parts by mass relative to a total of 100 parts by mass of component (A) and component (B), in a temperature range of 50 to 150°C, and then molding into a granular form in which the average particle size is in the range of 0.1 to 10.0 mm.

15. A method for molding a cured product, comprising at least the following steps (I) to (III):
(I) Step of melting the granular curable silicone composition according to any one of claims 1 to 9 or the pellet molded product or tablet molded product according to claim 10 by heating to 100°C or higher;
(II) Step of injecting the curable silicone composition obtained in the aforementioned step (I) into a metal die or step of distributing the curable silicone composition obtained in the aforementioned step (I) to a metal die by clamping; and
(III) Step of curing the curable silicone composition injected in the aforementioned step (II).

16. The method for molding a cured product according to claim 15, further comprising a coating step in which overmolding and underfilling of a semiconductor element are performed once using a cured product obtained by curing the granular curable silicone composition according to any one of claims 1 to 9 or the pellet molded product or tablet molded product according to claim 10.

17. The method for molding a cured product according to claim 15, further comprising a coating step of coating a surface of a semiconductor substrate on which one or a plurality of semiconductor elements are mounted with a cured product obtained by curing the granular curable silicone composition according to any one of claims 1 to 9 or the pellet molded product or tablet molded product according to claim 10, and then overmolding such that gaps in the semiconductor element are filled with the cured product.
